# EUROPEAN PATENT APPLICATION

(11) **EP 3 708 571 A1**
(43) Date of publication of application: **16.09.2020**
(21) Application number: 18876308.0
(22) Date of filing: 07.11.2018
(51) Int. Cl.: C07F 15/00, C09K 11/06, G09F 9/30, H01L 27/32, H01L 51/50

(54) **IRIDIUM COMPLEX COMPOUND, COMPOSITION CONTAINING SAID COMPOUND AND SOLVENT, ORGANIC ELECTROLUMINESCENT ELEMENT CONTAINING SAID COMPOUND, DISPLAY DEVICE, AND ILLUMINATION DEVICE**

(30) Priority: 07.11.2017 JP 2017214771; 07.11.2017 JP 2017214772
(71) Applicant: Mitsubishi Chemical Corporation, Tokyo 100-8251 (JP)
(72) Inventor: NAGAYAMA, Kazuhiro, Tokyo 100-8251 (JP); IEMURA, Oki, Tokyo 100-8251 (JP)
(74) Representative: Hoffmann Eitle
(86) International application number: PCT/JP2018/041327
(87) International publication number: WO 2019/093369

(57) **Abstract**

Provided is an iridium complex compound represented by formula (1) below. 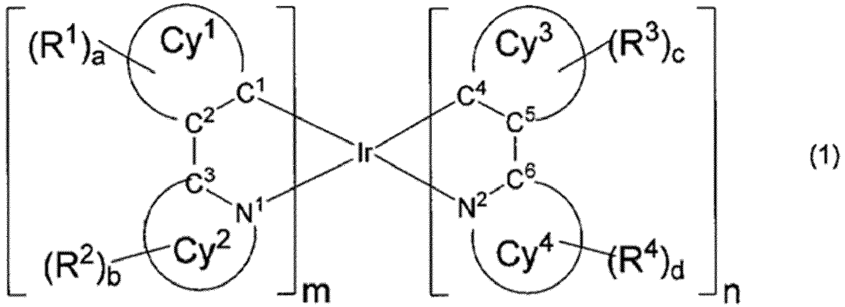 [Ir is an iridium atom. C¹ to C⁶ are carbon atoms. N¹ and N² are nitrogen atoms. R¹ to R⁴ are each a hydrogen atom or a substituent. a to d are maximum integer numbers of possible substituents on rings Cy¹ to Cy⁴, respectively. m and n are each 1 or 2, and m + n = 3. The ring Cy¹ is represented by formula (2) or (2') below. The ring Cy³ is an aromatic or heteroaromatic ring including the carbon atoms C⁴ and C⁵. The ring Cy⁴ is a heteroaromatic ring including the carbon atom C⁶ and the nitrogen atom N².]

## Description

### Technical Field

The present invention relates to an iridium complex compound, and particularly relates to an iridium complex compound useful as a material for a light-emitting layer of an organic electroluminescent element (hereinafter also referred to as an "organic EL element"). The present invention also relates to a composition containing the compound and a solvent, an organic electroluminescent element containing the compound, a display device including the organic electroluminescent element, and an illumination device including the organic electroluminescent element.

### Background Art

Various electronic devices in which organic EL elements are used, such as organic EL illuminators and organic EL displays, have been put to practical use. Organic electroluminescent elements, which consume little power because of their low applied voltage and are also enable light emission of three primary colors, are finding applications not only in large-sized display monitors but also in medium- and small-sized displays typified by cellular phones and smartphones.

Organic electroluminescent elements are produced by stacking a plurality of layers such as a light-emitting layer, a charge injection layer, and a charge transport layer. Currently, many of the organic electroluminescent elements are produced by depositing organic materials under vacuum, but vacuum deposition methods involve complex deposition processes and are poor in productivity. It is very difficult to provide a large-sized panel for an illuminator or a display by using an organic electroluminescent element produced by a vacuum deposition method.

In recent years, wet film-forming methods (application methods) have been studied as processes for efficiently producing an organic electroluminescent element that can be used in a large-sized display or illuminator. Wet film-forming methods, as compared to vacuum deposition methods, have the advantage of being able to easily form stable layers, and thus are expected to enable mass production of displays and illumination devices and to be used for large-sized devices.

To produce an organic electroluminescent element by a wet film-forming method, materials used all need to dissolve in an organic solvent and to be able to be used in the form of an ink. If the materials used have poor solvent solubility, operations such as long-time heating are required, and thus the materials may deteriorate before use. Furthermore, if homogeneity cannot be maintained for a long time in the state of a solution, the materials may precipitate from the solution, thus making it impossible to form a film with an ink-jet apparatus or the like.

Materials used in a wet film-forming method are required to have solubility with two meanings, i.e., to be rapidly soluble in an organic solvent and to maintain homogeneity without precipitation after the dissolution.

In recent years, there has been an increasing need for increase in density of such an ink. This is because by forming a light-emitting layer having a larger thickness using an ink with a high density, improvements have been made: for example, the operating lifetime of an element has been prolonged, and color purity has been increased by optimizing the optical design of an element to effectively produce what is called a microcavity effect.

Thus, materials for wet film formation of an organic electroluminescent element are required to have solvent solubility higher than those of materials of the related art.

Examples of high-performance light-emitting materials used in wet film-forming methods include phosphorescent iridium complex compounds having high light emission efficiency. Attempts have been made to achieve improvements in color tone, light emission efficiency, and element operating lifetime by devising ligands of iridium complex compounds (e.g., PTLs 1 to 7 and NPL 1).

PTL 1: International Publication No. 2015/087961
PTL 2: Japanese Unexamined Patent Application Publication No. 2016-64998
PTL 3: International Publication No. 2014/024889
PTL 4: Japanese Unexamined Patent Application Publication No. 2006-151888
PTL 5: Japanese Unexamined Patent Application Publication No. 2002-332291
PTL 6: U.S. Patent Application Publication No. 2016/0351835
PTL 7: U.S. Patent Application Publication No. 2016/0233442
NPL 1: S. Okada et al, Dalton Transactions, 2005, 1583-1590.

Iridium complex compounds generally have poor solvent solubility and thus are required to be provided with solvent solubility through introduction of a highly flexible substituent into a ligand.

On the other hand, to make an organic electroluminescent element emit light with a desired color tone, there is a need to introduce a substituent for wavelength adjustment into a ligand. The latter is important particularly in the case of a material having a wavelength longer than that of green, particularly, a red-light-emitting iridium material required to have a maximum emission wavelength of 600 nm or more.

In the case of a red-light-emitting iridium complex of the related art, when the number of substituents are large, and their position and type or the combination of ligands themselves is not appropriate, high solvent solubility is not provided.

No guidelines for a material design that can provide both solubility and desired chromaticity have been fully established.

In organic EL illuminators, further improvements in color reproducibility have been investigated. Color reproducibility improves under a light source having more wavelength components. It is required to increase the width of an emission spectrum of a light-emitting material, in other words, to develop a light-emitting material having an emission spectrum with a larger half-width.

The present inventors synthesized an iridium complex compound by reference to structures specifically disclosed in PTLs 3 to 5 and investigated the performance of the compound used as a red-light-emitting material. Although there was an improvement in solvent solubility, the compound had a low luminescent quantum yield, suggesting that the light emission properties of the compound used as an organic EL material might be impaired.

Iridium complex compounds specifically described in PTLs 6 and 7 have excessively large fused-ring structures and thus do not exhibit high solvent solubility.

The present inventors have discovered that red-light-emitting materials of the related art have solvent solubility insufficient for use in wet film-forming methods and have low luminescent quantum yields, and thus further improvements are required regarding high solubility of an iridium complex compound in a solvent, storage stability of a composition containing an iridium complex compound and a solvent, and higher light emission efficiency of an organic electroluminescent element including an iridium complex compound.

### Summary of Invention

An object of the present invention is to provide an iridium complex compound that can provide both high solvent solubility and target chromaticity, particularly, an iridium complex compound that combines high solvent solubility and red-light emission. Another object of the present invention is to provide an iridium complex compound that has, in addition to the above characteristics, an emission spectrum with a large half-width and can achieve a high color reproduction rate when used in illumination applications.

Still another object of the present invention is to provide an iridium complex compound that can provide high solvent solubility, storage stability, and light emission properties and that is suitable as a light-emitting material for an organic electroluminescent element of wet film-formation type.

The present inventors have discovered that an iridium complex compound having a specific chemical structure, as a red-light-emitting material, exhibits much higher solvent solubility than materials of the related art.

The present inventors have further discovered that an iridium complex compound having a specific chemical structure, as a red-light-emitting material, has an emission spectrum with a half-width larger than those of materials of the related art.

In addition, the present inventors have discovered that an iridium complex compound having a specific chemical structure has high storage stability and exhibits highly efficient light emission.

Thus, the gist of the present invention is as follows.
[1] An iridium complex compound represented by formula (1) below: 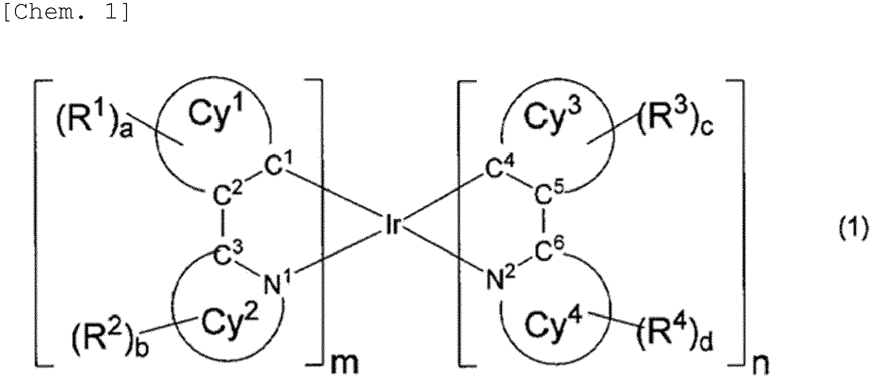 [in formula (1), Ir represents an iridium atom,
   C¹ to C⁶ represent carbon atoms, N¹ and N² represent nitrogen atoms,
   R¹ to R⁴ each independently represent a hydrogen atom or a substituent,
   a, b, c, and d represent maximum integer numbers of possible substituents on rings Cy¹, Cy², Cy³, and Cy⁴, respectively,
   m and n each represent 1 or 2, m + n is 3,
   the ring Cy¹ is a fluorene structure represented by formula (2) or (2') below, 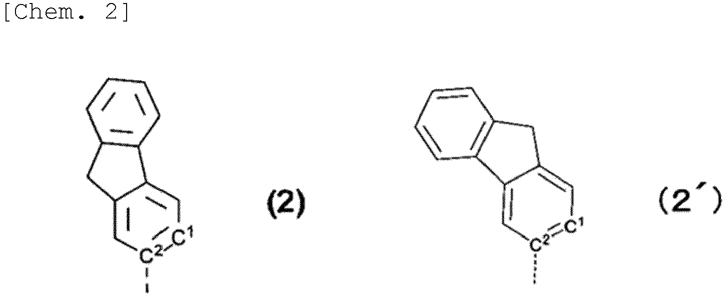
   when the ring Cy¹ is represented by formula (2), the ring Cy² is a quinoline or naphthyridine structure represented by any one of formula (3) to formula (5) below,
   when the ring Cy¹ is represented by formula (2'), the ring Cy² is a naphthyridine structure represented by any one of formula (3) to formula (5) below, 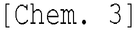 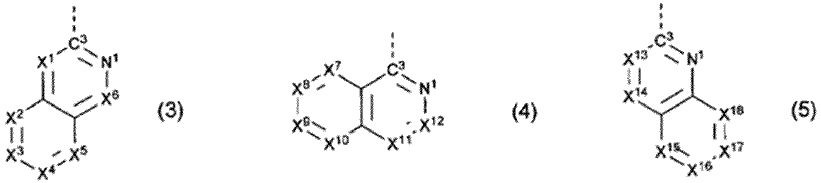 X¹ to X¹⁸ in formulae (3) to (5) each independently represent a carbon atom or a nitrogen atom,
   the ring Cy³ represents an aromatic or heteroaromatic ring including the carbon atoms C⁴ and C⁵, and
   the ring Cy⁴ represents a heteroaromatic ring including the carbon atom C⁶ and the nitrogen atom N²].
[2] The iridium complex compound according to [1], wherein the ring Cy⁴ is a structure represented by formula (6) below: 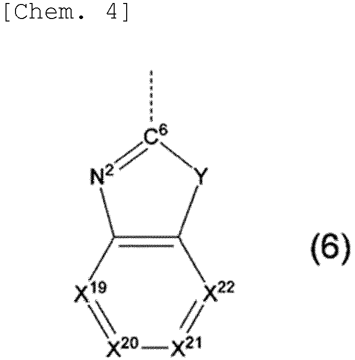 [in formula (6),
   X¹⁹ to X²² each independently represent a carbon atom or a nitrogen atom,
   Y represents N(-R⁵), an oxygen atom, or a sulfur atom, and R⁵ represents a hydrogen atom or a substituent].
[3] The iridium complex compound according to [1] or [2], wherein the ring Cy¹ is a fluorene structure represented by formula (2), and the ring Cy³ is represented by formula (8) below: 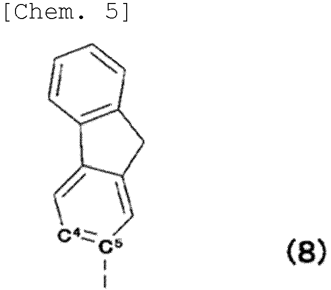
[4] The iridium complex compound according to any one of [1] to [3], wherein Y in formula (6) is a sulfur atom.
[5] The iridium complex compound according to any one of [1] to [4], wherein the ring Cy² includes two nitrogen atoms.
[6] A composition comprising the iridium complex compound according to any one of [1] to [5] and a solvent.
[7] An organic electroluminescent element comprising the iridium complex compound according to any one of [1] to [5].
[8] A display device comprising the organic electroluminescent element according to [7].
[9] An illumination device comprising the organic electroluminescent element according to [7].
[10] An iridium complex compound represented by formula (7) below: 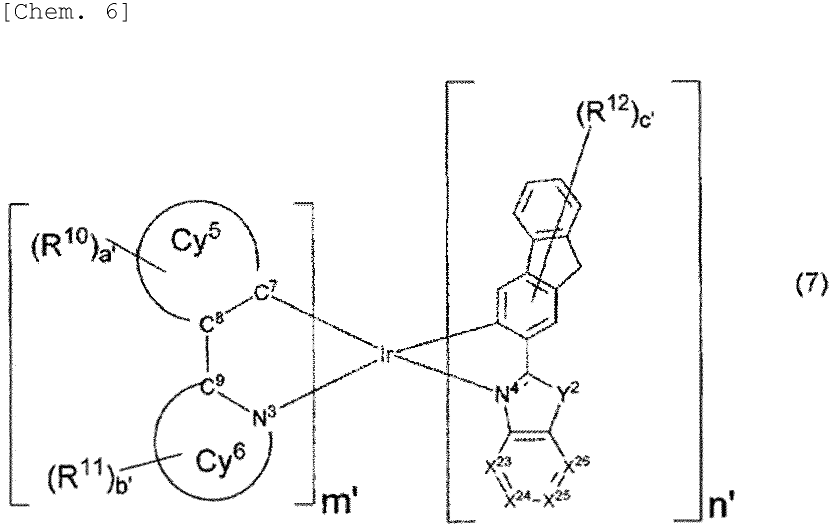 [in formula (7), Ir represents an iridium atom,
   C⁷ to C⁹ represent carbon atoms, N³ and N⁴ represent nitrogen atoms,
   a ring Cy⁵ represents an aromatic or heteroaromatic ring including the carbon atoms C⁷ and C⁸,
   a ring Cy⁶ represents a heteroaromatic ring including the carbon atom C⁹ and the nitrogen atom N³,
   X²³ to X²⁶ each independently represent an optionally substituted carbon atom or a nitrogen atom,
   Y² represents an oxygen atom, a sulfur atom, or a selenium atom,
   R¹⁰ to R¹² each independently represent a hydrogen atom or a substituent,
   a' and b' represent maximum integer numbers of possible substituents on the rings Cy⁵ and Cy⁶, respectively, c' is 8, and
   m' and n' each represent 1 or 2, m' + n' is 3]. Advantageous Effects of Invention

The iridium complex compound of the present invention has high solvent solubility, and thus an organic electroluminescent element can be produced using the compound by a wet film-forming method. The organic electroluminescent element of the present invention is useful for an organic EL display device and an illumination device.

In addition, the iridium complex compound of the present invention, as a red-light-emitting material, has an emission spectrum with a half-width larger than those of materials of the related art and can achieve a high color reproduction rate when used in illumination applications.

In addition, the iridium complex compound of the present invention has a high luminescent quantum yield and can provide an organic electroluminescent element having excellent light emission properties.

### Brief Description of Drawings

[Fig. 1] Fig. 1 is a sectional view schematically illustrating an example of a structure of an organic electroluminescent element of the present invention.
[Fig. 2] Fig. 2 is a graph showing the relationship between maximum emission wavelength and half-width of compounds of Examples 3 and 4 and Comparative Examples 3 and 4.
[Fig. 3] Fig. 3 is a graph showing the relationship between maximum emission wavelength and luminescent quantum yield of compounds of Example 5 and Comparative Examples 5 to 7.

### Description of Embodiments

Embodiments of the present invention will now be described in detail, but the present invention is not limited to the following embodiments and can be practiced with various modifications within the scope of the gist of the invention.

As used herein, the term "aromatic ring" refers to an "aromatic hydrocarbon ring" and is distinct from a "heteroaromatic ring" which includes a heteroatom as an annular atom. Similarly, the term "aromatic group" refers to an "aromatic hydrocarbon ring group", and the term "heteroaromatic group" refers to a "heteroaromatic ring group".

### [Iridium complex compound]

An iridium complex compound of the present invention is a compound represented by formula (1) below. 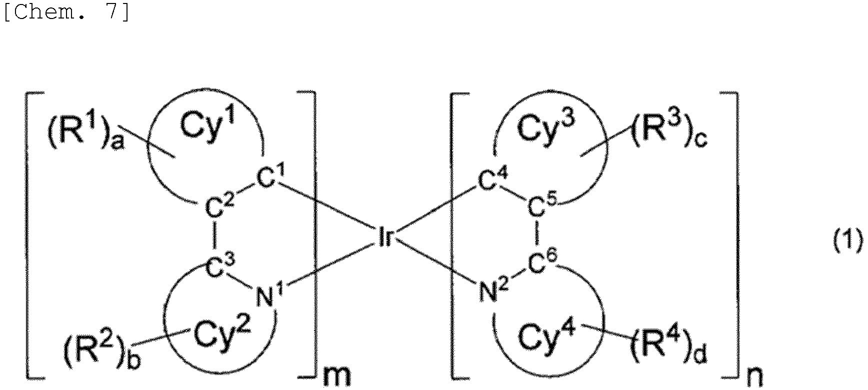 [in formula (1), Ir represents an iridium atom,
C¹ to C⁶ represent carbon atoms, N¹ and N² represent nitrogen atoms,
R¹ to R⁴ each independently represent a hydrogen atom or a substituent,
a, b, c, and d represent maximum integer numbers of possible substituents on rings Cy¹, Cy², Cy³, and Cy⁴, respectively,
m and n each represent 1 or 2, m + n is 3]

The reason why the iridium complex compound of the present invention provides both high solvent solubility and target chromaticity is presumably as follows.

Introducing a fluorene skeleton into a ligand is preferred because the combination with a ring Cy² skeleton readily enables an emission wavelength in the target red region, but on the other hand, due to a very highly planar structure in which free rotational motion of two benzene rings is inhibited, solubility in a solvent and dissolution stability by which homogeneity is maintained and no precipitates are formed in the form of an ink are usually very poor. To improve the solvent solubility, for example, introduction of a long-chain alkyl group or the like into the 9-position of fluorene is being practiced, but when such a compound is used as a light-emitting material for an organic electroluminescent element, the insulating long-chain alkyl group considerably shields the HOMO orbital of a complex molecule to inhibit oxidation of the molecule, and the likelihood of charge recombination on the complex is reduced, as a result of which the element performance will probably degrade.

In one preferred embodiment of the present invention, specific ligands are combined to be heteroleptic, whereby the solvent solubility can be improved without the need for the long-chain alkyl group.

The reason why the iridium complex compound of the present invention provides both high solvent solubility and a high luminescent quantum yield is presumably as follows.

To improve the quantum yield, the phosphorescence radiative rate constant kr of a light-emitting material needs to be high. For this purpose, for example, a rigid chemical structure is employed to prevent energy dissipation due to thermal vibration, or the LUMO is lowered, for example, by introducing an electron-withdrawing substituent into a ligand to increase MLCT properties in an excited state.

From this viewpoint, for example, a fluorene structure, which is considerably rigid because two benzene rings are bonded together through a direct bond and through an optionally substituted methylene group, may be preferable. If the rigid structure is excessively large, the interaction between molecules is so strong that the solubility is greatly impaired, and thus there is a need to avoid further introducing a fused-ring structure into a fluorene ring. Although a fluorene group itself is considered to have some degree of electron-donating properties due to the presence of a methylene group, in the case of a ligand structure having a heteroaromatic ring at the 3-position of a fluorene ring as in an iridium complex compound in another preferred embodiment of the present invention, the heteroaromatic ring and two benzene rings of the fluorene ring do not lie on a straight line, and thus the conjugation is not strong. Consequently, the LUMO of the ligand is not lowered, and the MLCT properties are kept high.

### <Ring Cy¹>

The ring Cy¹ is a structure represented by formula (2) or (2') below including the carbon atoms C¹ and C² coordinating to the iridium atom. Although the substituent (R¹)ₐ- is omitted in formulae (2) and (2') below, the ring Cy¹, inclusive of the substituent (R¹)ₐ-, is preferably a 9,9-dimethylfluorene ring as illustrated in specific examples of the iridium complex compound of the present invention given later.

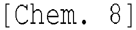

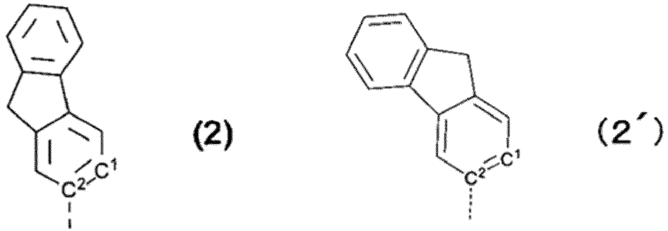

When the high solvent solubility and the target chromaticity of the iridium complex compound of the present invention are particularly achieved at the same time, the ring Cy¹ is preferably the structure represented by formula (2). When the high solvent solubility and the high luminescent quantum yield of the iridium complex compound of the present invention are particularly achieved at the same time, the ring Cy¹ is preferably the structure represented by formula (2').

### <Ring Cy²>

The ring Cy² is a structure represented by any one of formulae (3) to (5) below. When the ring Cy¹ is a structure represented by formula (2), the ring Cy² is preferably a quinoline or naphthyridine structure represented by any one of formula (3) to formula (5) below. When the ring Cy¹ is a structure represented by formula (2'), the ring Cy² is preferably a naphthyridine structure represented by any one of formula (3) to formula (5) below.

In formulae (3) to (5) below, the substituent (R²)_{b}- is omitted.

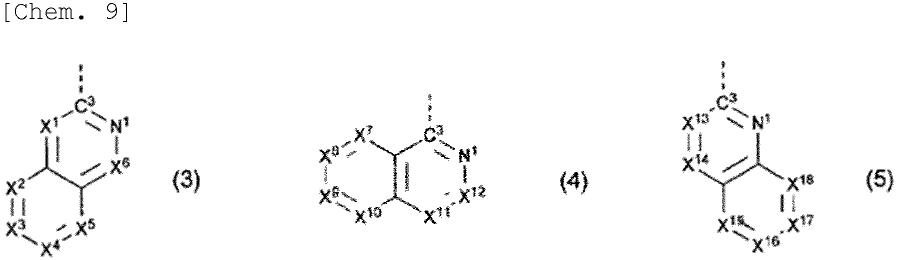

X¹ to X¹⁸ in formulae (3) to (5) each independently represent a carbon atom or a nitrogen atom.

The number of nitrogen atoms, inclusive of the nitrogen atom N¹, in the ring Cy² is preferably 3 or less, more preferably 2 or less. When the number of nitrogen atoms is 3 or less, HOMO and LUMO of the iridium complex compound cannot be excessively deep, and both holes and electrons are readily injected into the complex molecule. Thus, recombination is less likely to occur, which is a tendency favorable to a light-emitting material for an organic electroluminescent element.

Among the above structures, the ring Cy² is preferably a structure represented by formula (3) or formula (5), particularly preferably a structure represented by formula (3), because preferred chromaticity of red-light emission of an organic EL display is exhibited. To increase the color purity of red and to make the ligand more electron-donating and enhance the MLCT properties, the ring Cy² is preferably a naphthyridine structure, such as quinazoline or quinoxaline, in which the number of annular nitrogen atoms is two, inclusive of N¹, rather than a quinoline structure in which the annular nitrogen atom is N¹ alone.

### <Ring Cy³>

The ring Cy³ represents an aromatic or heteroaromatic ring including the carbon atoms C⁴ and C⁵ coordinating to the iridium atom.

The ring Cy³ may be a monocyclic ring or a fused ring formed of a plurality of rings bonded together. In the case of a fused ring, the number of rings is not particularly limited and is preferably 6 or less, and preferably 5 or less because the solvent solubility of the complex tends not to be impaired.

Although not particularly limited, when the ring Cy³ is a heteroaromatic ring, the heteroatom included as an annular atom in addition to the carbon atoms is preferably selected from a nitrogen atom, an oxygen atom, a sulfur atom, a silicon atom, a phosphorus atom, and a selenium atom, from the viewpoint of chemical stability of the complex.

Specific examples of the ring Cy³ include, in the case of aromatic rings, monocyclic rings such as a benzene ring; bicyclic rings such as a naphthalene ring; and tri- or higher cyclic rings such as a fluorene ring, an anthracene ring, a phenanthrene ring, a perylene ring, a tetracene ring, a pyrene ring, a benzpyrene ring, a chrysene ring, a triphenylene ring, and a fluoranthene ring. In the case of heteroaromatic rings, specific examples include oxygen-containing rings such as a furan ring, a benzofuran ring, and a dibenzofuran ring; sulfur-containing rings such as a thiophene ring, a benzothiophene ring, and a dibenzothiophene ring; nitrogen-containing rings such as a pyrrole ring, a pyrazole ring, an imidazole ring, a benzimidazole ring, an indole ring, an indazole ring, a carbazole ring, an indolocarbazole ring, an indenocarbazole ring, a pyridine ring, a pyrazine ring, a pyridazine ring, a pyrimidine ring, a triazine ring, a quinoline ring, an isoquinoline ring, a cinnoline ring, a phthalazine ring, a quinoxaline ring, a quinazoline ring, a quinazolinone ring, an acridine ring, a phenanthridine ring, a carboline ring, and a purine ring; and rings including two or more different heteroatoms, such as an oxazole ring, an oxadiazole ring, an isoxazole ring, a benzisoxazole ring, a thiazole ring, a benzothiazole ring, an isothiazole ring, and a benzisothiazole ring.

Of these, to control the emission wavelength, improve the solubility in an organic solvent, and provide an organic electroluminescent element with improved durability, rings onto which an appropriate substituent is often introduced and for which many methods of introducing such a substituent are known are preferred. Thus, among the above specific examples, rings in which one ring including the carbon atom C⁴ directly bonded to the iridium atom is a benzene ring are preferred. Examples thereof include, in addition to the aromatic rings described above, a dibenzofuran ring, a dibenzothiophene ring, a carbazole ring, an indolocarbazole ring, and an indenocarbazole ring. Of these, a benzene ring, a naphthalene ring, a fluorene ring, a dibenzofuran ring, a dibenzothiophene ring, and a carbazole ring are more preferred. In particular, to increase the half-width while maintaining the solvent solubility, the ring Cy³ is most preferably a fluorene ring represented by formula (8) below. In formula (8) below, the substituent (R³)_{c}- is omitted.

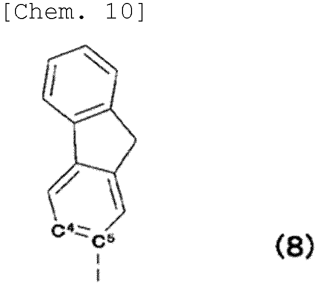

The number of atoms constituting the ring Cy³ is not particularly limited, but to maintain the solvent solubility of the iridium complex compound, the number of atoms constituting the ring is preferably 5 or more, more preferably 6 or more. The number of atoms constituting the ring is preferably 30 or less, more preferably 20 or less.

### <Ring Cy⁴>

The ring Cy⁴ represents a heteroaromatic ring including the carbon atom C⁶ and the nitrogen atom N² coordinating to the iridium atom.

Specific examples of the ring Cy⁴ include monocyclic rings such as a pyridine ring, a pyridazine ring, a pyrimidine ring, a pyrazine ring, a triazine ring, a pyrrole ring, a pyrazole ring, an isoxazole ring, a thiazole ring, an oxazole ring, an oxadiazole ring, a thiazole ring, and a purine ring; bicyclic fused rings such as a quinoline ring, an isoquinoline ring, a cinnoline ring, a phthalazine ring, a quinazoline ring, a quinoxaline ring, a naphthyridine ring, an indole ring, an indazole ring, a benzisoxazole ring, a benzisothiazole ring, a benzimidazole ring, a benzoxazole ring, and a benzothiazole ring; tricyclic fused rings such as an acridine ring, a phenanthroline ring, a carbazole ring, and a carboline ring; and tetra- or higher cyclic fused rings such as a benzophenanthridine ring, a benzacridine ring, and an indolocarboline ring. Furthermore, carbon atoms constituting these rings may be further substituted with nitrogen atoms.

Of these, the ring Cy⁴ is preferably a monocyclic ring or a tetra- or lower cyclic fused ring, more preferably a monocyclic ring or a tri- or lower cyclic fused ring, most preferably a monocyclic ring or a bicyclic fused ring, because the emission wavelength and the solvent solubility are easily adjusted due to the ease of introduction of a substituent, and because there are many known methods by which a complex with iridium can be synthesized in good yield. Specifically, the ring Cy⁴ is preferably an imidazole ring, an oxazole ring, a thiazole ring, a benzimidazole ring, a benzoxazole ring, a benzothiazole ring, a pyridine ring,a quinoline ring, an isoquinoline ring, a pyridazine ring, a pyrimidine ring, a pyrazine ring, a triazine ring, a cinnoline ring, a phthalazine ring, a quinazoline ring, a quinoxaline ring, or a naphthyridine ring, more preferably an imidazole ring, an oxazole ring, a quinoline ring, an isoquinoline ring, a pyridazine ring, a pyrimidine ring, or a pyrazine ring, particularly preferably a benzimidazole ring, a benzoxazole ring, a benzothiazole ring, a pyridine ring, an isoquinoline ring, a pyridazine ring, a pyrimidine ring, or a pyrazine ring, most preferably a structure represented by formula (6) below. In formula (6), the substituent (R⁴)_{d}- is omitted.

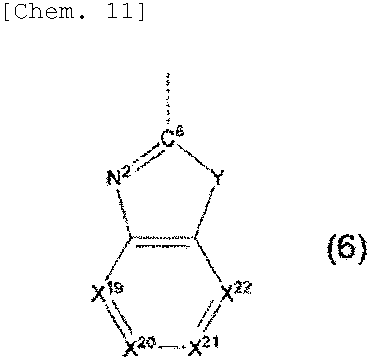

X¹⁹ to X²² in formula (6) each independently represent a carbon atom or a nitrogen atom. In view of the ease of adjustment of the emission wavelength particularly to the red region and the ease of synthesis of a complex, the number of nitrogen atoms in X¹⁹ to X²² is preferably 0 or 1.

When X¹⁹ to X²² are carbon atoms, hydrogen atoms may be bonded to the carbon atoms, and the carbon atoms may each be substituted with any of substituents represented by R¹ to R⁵ described below, preferably with F, an alkyl group, an aromatic group, or a heteroaromatic group. In order not to impair the solubility of the iridium complex compound, the number of atoms constituting the ring Cy⁴ is preferably 14 or less, more preferably 13 or less.

Y represents N(-R⁵), an oxygen atom, or a sulfur atom. R⁵ represents a hydrogen atom or a substituent.

In formula (6), Y is preferably N(-R⁵) or a sulfur atom, most preferably a sulfur atom, because the aromaticity of the 5-membered ring moiety is preferably higher for a more chemically stable structure and also for the stability of the complex.

When R⁵ is a substituent, the substituent has the same meanings and the same preferred ranges as the substituents represented by R¹ to R⁴ specifically described below, though not particularly limited.

### <R¹ to R⁴ and a to d>

R¹ to R⁴ in formula (1) represent a hydrogen atom or a substituent. R¹ to R⁴ are independent of each other and may be the same or different.

a to d are maximum integer numbers of possible substituents on the ring Cy¹ to the ring Cy⁴, respectively, and a is 8. When a to d are 2 or more, the pluralities of R¹ to R⁴ may each be the same or different.

For each of R¹ to R⁴, two or more adjacent ones may be bonded together to form an aliphatic, aromatic, or heteroaromatic, monocyclic or fused ring, but to suppress a decrease in solvent solubility, R¹ is preferably not fused to the ring Cy¹ such that two or more adjacent R¹ are bonded together to form an aliphatic, aromatic, or heteroaromatic.

When R¹ to R⁴ are substituents, the types thereof are not particularly limited, and optimal substituents can be selected taking into account, for example, precise control of the desired emission wavelength, the affinity with a solvent used, and the affinity with a host compound in the case where an organic electroluminescent element is produced. In considering the optimization, preferred substituents are within the range described below.

R¹ to R⁴ are each independently selected from a hydrogen atom, D, F, Cl, Br, I, -N(R')₂, -CN, -NO₂, -OH, -COOR', - C(=O)R', -C(=O) NR', -P(=O) (R')₂, -S(=O)R', -S(=O)₂R', - OS(=O)₂R', a linear, branched, or cyclic alkyl group having 1 to 30 carbon atoms, a linear, branched, or cyclic alkoxy group having 1 to 30 carbon atoms, a linear, branched, or cyclic alkylthio group having 1 to 30 carbon atoms, a linear, branched, or cyclic alkenyl group having 2 to 30 carbon atoms, a linear, branched, or cyclic alkynyl group having 2 to 30 carbon atoms, an aromatic group having 5 to 60 carbon atoms, a heteroaromatic group having 5 to 60 carbon atoms, an aryloxy group having 5 to 40 carbon atoms, an arylthio group having 5 to 40 carbon atoms, an aralkyl group having 5 to 60 carbon atoms, a heteroaralkyl group having 5 to 60 carbon atoms, a diarylamino group having 10 to 40 carbon atoms, an arylheteroarylamino group having 10 to 40 carbon atoms, and a diheteroarylamino group having 10 to 40 carbon atoms.

The alkyl group, the alkoxy group, the alkylthio group, the alkenyl group, and the alkynyl group may be further substituted with one or more R', and one -CH₂- group or two or more non-adjacent -CH₂- groups in these groups may be substituted with -C(-R')=C(-R')-, -C≡C-, -Si(-R')₂-, -C(=O)-, -NR'-, -O-, -S-, -CONR'-, or a divalent aromatic group. One or more hydrogen atoms in these groups may be substituted with D, F, Cl, Br, I, or -CN.

The aromatic group, the heteroaromatic group, the aryloxy group, the arylthio group, the aralkyl group, the heteroaralkyl group, the diarylamino group, the arylheteroarylamino group, and the diheteroarylamino group may each independently be further substituted with one or more R'.

R' will be described later.

Examples of the linear, branched, or cyclic alkyl group having 1 to 30 carbon atoms include a methyl group, an ethyl group, an n-propyl group, an isopropyl group, an n-butyl group, an n-pentyl group, an n-hexyl group, an n-octyl group, a 2-ethylhexyl group, an isopropyl group, an isobutyl group, a cyclopentyl group, a cyclohexyl group, an n-octyl group, a norbornyl group, and an adamantyl group. From the viewpoint of durability, the number of carbon atoms is preferably 1 or more, and preferably 30 or less, more preferably 20 or less, most preferably 12 or less.

Examples of the linear, branched, or cyclic alkoxy group having 1 to 30 carbon atoms include a methoxy group, an ethoxy group, an n-propyloxy group, an n-butoxy group, an n-hexyloxy group, an isopropyloxy group, a cyclohexyloxy group, a 2-ethoxyethoxy group, and a 2-ethoxyethoxyethoxy group. From the viewpoint of durability, the number of carbon atoms is preferably 1 or more, and preferably 30 or less, more preferably 20 or less, most preferably 12 or less.

Examples of the linear, branched, or cyclic alkylthio group having 1 to 30 carbon atoms include a methylthio group, an ethylthio group, an n-propylthio group, an n-butylthio group, an n-hexylthio group, an isopropylthio group, a cyclohexylthio group, a 2-methylbutylthio group, and an n-hexylthio group. From the viewpoint of durability, the number of carbon atoms is preferably 1 or more, and preferably 30 or less, more preferably 20 or less, most preferably 12 or less.

Examples of the linear, branched, or cyclic alkenyl group having 2 to 30 carbon atoms include a vinyl group, an allyl group, a propenyl group, a heptenyl group, a cyclopentenyl group, a cyclohexenyl group, and a cyclooctenyl group. From the viewpoint of durability, the number of carbon atoms is preferably 2 or more, and preferably 30 or less, more preferably 20 or less, most preferably 12 or less.

Examples of the linear, branched, or cyclic alkynyl group having 2 to 30 carbon atoms include an ethynyl group, a propionyl group, a butynyl group, a pentynyl group, a hexynyl group, a heptynyl group, and an octynyl group. From the viewpoint of durability, the number of carbon atoms is preferably 2 or more, and preferably 30 or less, more preferably 20 or less, most preferably 12 or less.

The aromatic group having 5 to 60 carbon atoms and the heteroaromatic group having 5 to 60 carbon atoms may be present in the form of a single ring or a fused ring, or may be a group formed through bonding or condensation between one ring and another type of aromatic group or heteroaromatic group.

Examples of such groups include a phenyl group, a naphthyl group, an anthracenyl group, a benzanthracenyl group, a phenanthrenyl group, a benzophenanthrenyl group, a pyrenyl group, a chrysenyl group, a fluoranthenyl group, a perylenyl group, a benzopyrenyl group, a benzofluoranthenyl group, a naphthacenyl group, a pentacenyl group, a biphenyl group, a terphenyl group, a fluorenyl group, a spirobifluorenyl group, a dihydrophenanthrenyl group, a dihydropyrenyl group, a tetrahydropyrenyl group, an indenofluorenyl group, a furyl group, a benzofuryl group, an isobenzofuryl group, a dibenzofuranyl group, a thiophene group, a benzothiophenyl group, a dibenzothiophenyl group, a pyrrolyl group, an indolyl group, an isoindolyl group, a carbazolyl group, a benzocarbazolyl group, an indolocarbazolyl group, an indenocarbazolyl group, a pyridyl group, a cinnolyl group, an isocinnolyl group, an acridyl group, a phenanthridyl group, a phenothiazinyl group, a phenoxazyl group, a pyrazolyl group, an indazolyl group, an imidazolyl group, a benzimidazolyl group, a naphthoimidazolyl group, a phenanthroimidazolyl group, a pyridinimidazolyl group, an oxazolyl group, a benzoxazolyl group, a naphthoxazolyl group, a thiazolyl group, a benzothiazolyl group, a pyrimidyl group, a benzopyrimidyl group, a pyridazinyl group, a quinoxalinyl group, a diazaanthracenyl group, a diazapyrenyl group, a pyrazinyl group, a phenoxazinyl group, a phenothiazinyl group, a naphthyridinyl group, an azacarbazolyl group, a benzocarbolinyl group, a phenanthrolinyl group, a triazolyl group, a benzotriazolyl group, an oxadiazolyl group, a thiadiazolyl group, a triazinyl group, a 2,6-diphenyl-1,3,5-triazin-4-yl group, a tetrazolyl group, a purinyl group, and a benzothiadiazolyl group.

From the viewpoint of the balance between solubility and durability, the number of carbon atoms in these groups is preferably 5 or more, and preferably 50 or less, more preferably 40 or less, most preferably 30 or less.

Examples of the aryloxy group having 5 to 40 carbon atoms include a phenoxy group, a methylphenoxy group, a naphtoxy group, and a methoxyphenoxy group. From the viewpoint of the balance between solubility and durability, the number of carbon atoms in these aryloxy groups is preferably 5 or more, and preferably 30 or less, more preferably 25 or less, most preferably 20 or less.

Examples of the arylthio group having 5 to 40 carbon atoms include a phenylthio group, a methylphenylthio group, a naphthylthio group, and a methoxyphenylthio group. From the viewpoint of the balance between solubility and durability, the number of carbon atoms in these arylthio groups is preferably 5 or more, and preferably 30 or less, more preferably 25 or less, most preferably 20 or less.

Examples of the aralkyl group having 5 to 60 carbon atoms include a 1,1-dimethyl-1-phenylmethyl group, a 1,1-di(n-butyl)-1-phenylmethyl group, a 1,1-di(n-hexyl)-1-phenylmethyl group, a 1,1-di(n-octyl)-1-phenylmethyl group, a phenylmethyl group, a phenylethyl group, a 3-phenyl-1-propyl group, a 4-phenyl-1-n-butyl group, a 1-methyl-1-phenylethyl group, a 5-phenyl-1-n-propyl group, a 6-phenyl-1-n-hexyl group, a 6-naphthyl-1-n-hexyl group, a 7-phenyl-1-n-heptyl group, an 8-phenyl-1-n-octyl group, and a 4-phenylcyclohexyl group. From the viewpoint of the balance between solubility and durability, the number of carbon atoms in these aralkyl groups is preferably 5 or more and more preferably 40 or less.

Examples of the heteroaralkyl group having 5 to 60 carbon atoms include a 1,1-dimethyl-1-(2-pyridyl)methyl group, a 1,1-di(n-hexyl)-1-(2-pyridyl)methyl group, a (2-pyridyl)methyl group, a (2-pyridyl)ethyl group, a 3-(2-pyridyl)-1-propyl group, a 4-(2-pyridyl)-1-n-butyl group, a 1-methyl-1-(2-pyridyl)ethyl group, a 5-(2-pyridyl)-1-n-propyl group, a 6-(2-pyridyl)-1-n-hexyl group, a 6-(2-pyrimidyl)-1-n-hexyl group, a 6-(2,6-diphenyl-1,3,5-triazin-4-yl)-1-n-hexyl group, a 7-(2-pyridyl)-1-n-heptyl group, an 8-(2-pyridyl)-1-n-octyl group, and a 4-(2-pyridyl)cyclohexyl group. From the viewpoint of the balance between solubility and durability, the number of carbon atoms in these heteroaralkyl groups is preferably 5 or more, and preferably 50 or less, more preferably 40 or less, most preferably 30 or less.

Examples of the diarylamino group having 10 to 40 carbon atoms include a diphenylamino group, a phenyl(naphthyl)amino group, a di(biphenyl)amino group, and a di(p-terphenyl)amino group. From the viewpoint of the balance between solubility and durability, the number of carbon atoms in these diarylamino groups is preferably 10 or more, and preferably 36 or less, more preferably 30 or less, most preferably 25 or less.

Examples of the arylheteroarylamino group having 10 to 40 carbon atoms include a phenyl(2-pyridyl)amino group and a phenyl(2,6-diphenyl-1,3,5-triazin-4-yl)amino group. From the viewpoint of the balance between solubility and durability, the number of carbon atoms in these arylheteroarylamino groups is preferably 10 or more, and preferably 36 or less, more preferably 30 or less, most preferably 25 or less.

Examples of the diheteroarylamino group having 10 to 40 carbon atoms include a di(2-pyridyl)amino group and a di(2,6-diphenyl-1,3,5-triazin-4-yl)amino group. From the viewpoint of the balance between solubility and durability, the number of carbon atoms in these diheteroarylamino groups is preferably 10 or more, and preferably 36 or less, more preferably 30 or less, most preferably 25 or less.

In order, particularly, not to impair the durability of a light-emitting material in an organic electroluminescent element, R¹ to R⁴ are each independently, preferably, a hydrogen atom, F, -CN, a linear, branched, or cyclic alkyl group having 1 to 30 carbon atoms, an aryloxy group having 5 to 40 carbon atoms, an arylthio group having 5 to 40 carbon atoms, a diarylamino group having 10 to 40 carbon atoms, an aralkyl group having 5 to 60 carbon atoms, an aromatic group having 5 to 60 carbon atoms, or a heteroaromatic group having 5 to 60 carbon atoms, particularly preferably, a hydrogen atom, F, -CN, an alkyl group, an aralkyl group, an aromatic group, or a heteroaromatic group, most preferably, a hydrogen atom, F, -CN, an alkyl group, an aromatic group, or a heteroaromatic group.

When R¹ to R⁴ are substituents, substitution positions thereof are not particularly limited. For the substituent R³, when the ring Cy³ is a benzene ring and importance is attached particularly to the durability of the complex, at least one R³ is preferably substituted at the 4-position or the 5-position of the benzene ring, more preferably substituted at the 4-position. R³ in this case is preferably the aromatic group or the heteroaromatic group described above.

For the substituent R², when a nitrogen atom that does not coordinate to the iridium atom is present in the ring Cy², at least one R² is preferably present at an adjacent position of the nitrogen atom. In this case, the nitrogen atom is shielded by steric hindrance, whereby external influences such as solvation tend to be diminished, thus reducing the influence on physical properties such as emission wavelength.

### <R'>

Each R' is independently selected from a hydrogen atom, D, F, Cl, Br, I, -N(R")₂, -CN, -NO₂, -Si(R")₃, -B(OR")₂, - C(=O)R", -P(=O) (R")₂, -S(=O)₂R", -OSO₂R", a linear, branched, or cyclic alkyl group having 1 to 30 carbon atoms, a linear, branched, or cyclic alkoxy group having 1 to 30 carbon atoms, a linear, branched, or cyclic alkylthio group having 1 to 30 carbon atoms, a linear, branched, or cyclic alkenyl group having 2 to 30 carbon atoms, a linear, branched, or cyclic alkynyl group having 2 to 30 carbon atoms, an aromatic group having 5 to 60 carbon atoms, a heteroaromatic group having 5 to 60 carbon atoms, an aryloxy group having 5 to 40 carbon atoms, an arylthio group having 5 to 40 carbon atoms, an aralkyl group having 5 to 60 carbon atoms, a heteroaralkyl group having 5 to 60 carbon atoms, a diarylamino group having 10 to 40 carbon atoms, an arylheteroarylamino group having 10 to 40 carbon atoms, and a diheteroarylamino group having 10 to 40 carbon atoms.

The alkyl group, the alkoxy group, the alkylthio group, the alkenyl group and the alkynyl group may be further substituted with one or more R", and one -CH₂- group or two or more non-adjacent -CH₂- groups in these groups may be substituted with -C(-R")=C(-R")-, -C≡C-, -Si(-R")₂-, -C(=O)-, -NR"-, -O-, -S-, -CONR"-, or a divalent aromatic group. One or more hydrogen atoms in these groups may be substituted with D, F, Cl, Br, I, or -CN.

The aromatic group, the heteroaromatic group, the aryloxy group, the arylthio group, the aralkyl group, the heteroaralkyl group, the diarylamino group, the arylheteroarylamino group, and the diheteroarylamino group may be further substituted with one or more R". R" will be described later.

Two or more adjacent R' may be bonded together to form an aliphatic, aromatic, or heteroaromatic, monocyclic or fused ring.

Examples of the above-described groups are all as described in the section of R¹ to R⁴.

### <R">

Each R" is independently selected from a hydrogen atom, D, F, -CN, an aliphatic hydrocarbon group having 1 to 20 carbon atoms, an aromatic group having 1 to 20 carbon atoms, and a heteroaromatic group having 1 to 20 carbon atoms.

Two or more adjacent R" may be bonded together to form an aliphatic, aromatic, or heteroaromatic, monocyclic or fused ring.

### <Combination of ring Cy³ and ring Cy⁴>

A combination of the ring Cy³ and the ring Cy⁴ serving as an auxiliary ligand that can increase the half-width of an emission spectrum and exhibit the most preferred performance in illumination applications is 2-(9H-fluoren-2-yl)benzothiazole.

### <Specific examples>

Specific examples of preferred iridium complex compounds of the present invention other than iridium complex compounds given in EXAMPLES described later will be given below, but the present invention is not limited thereto.

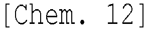

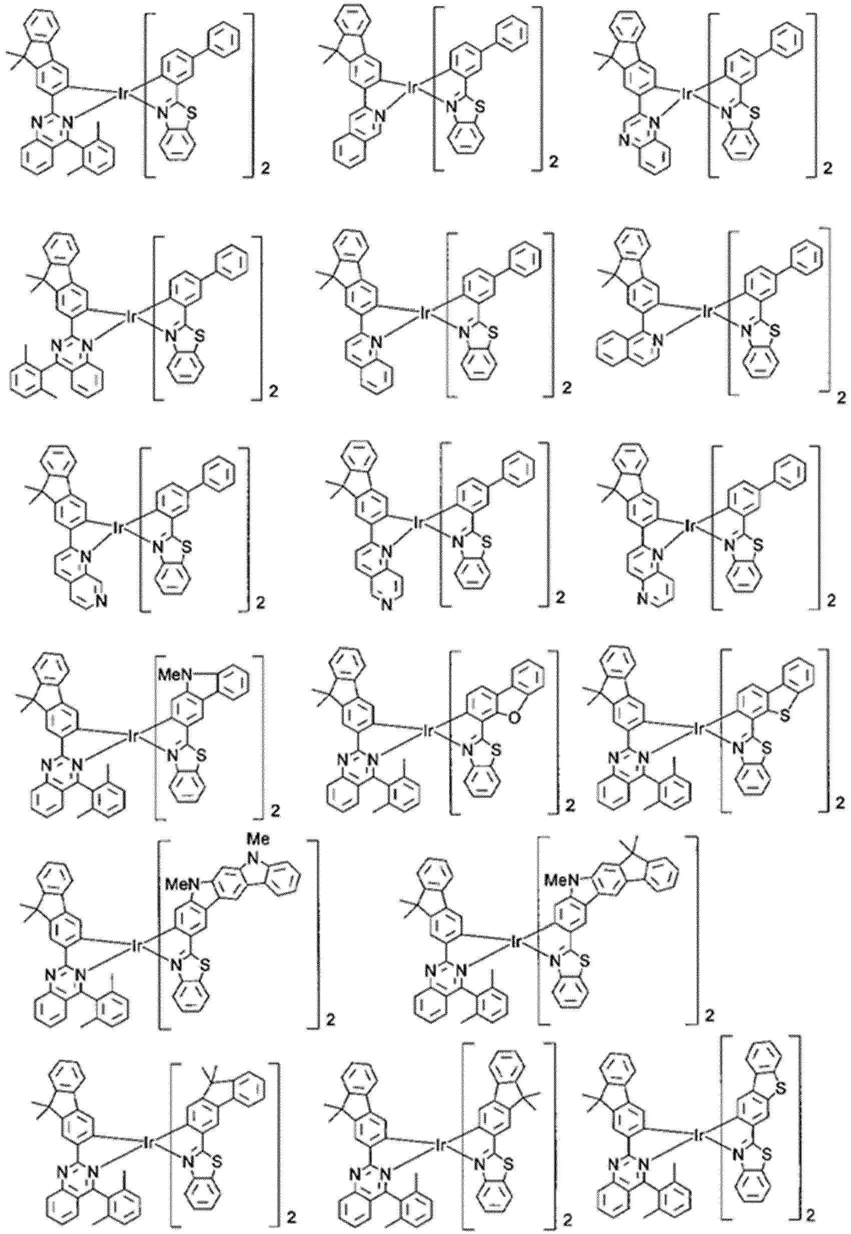

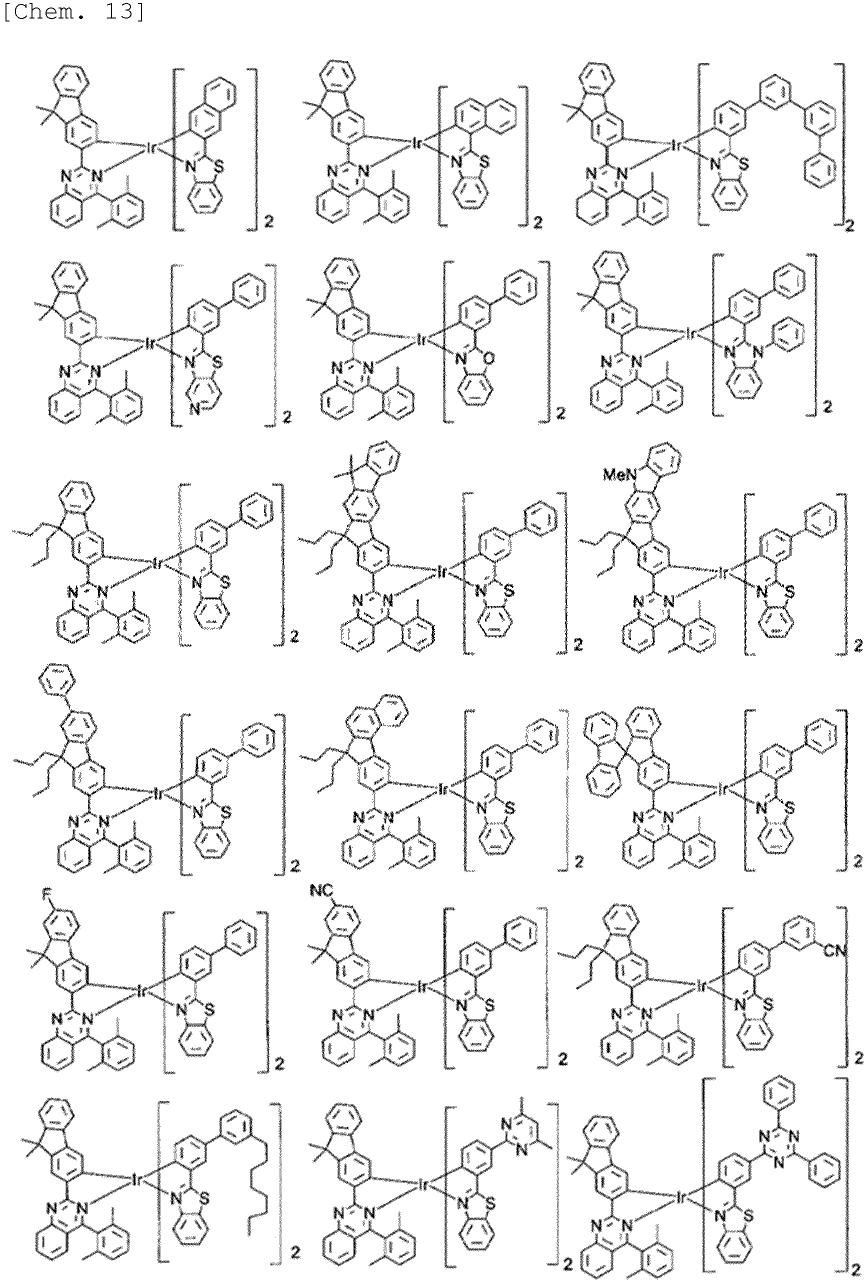

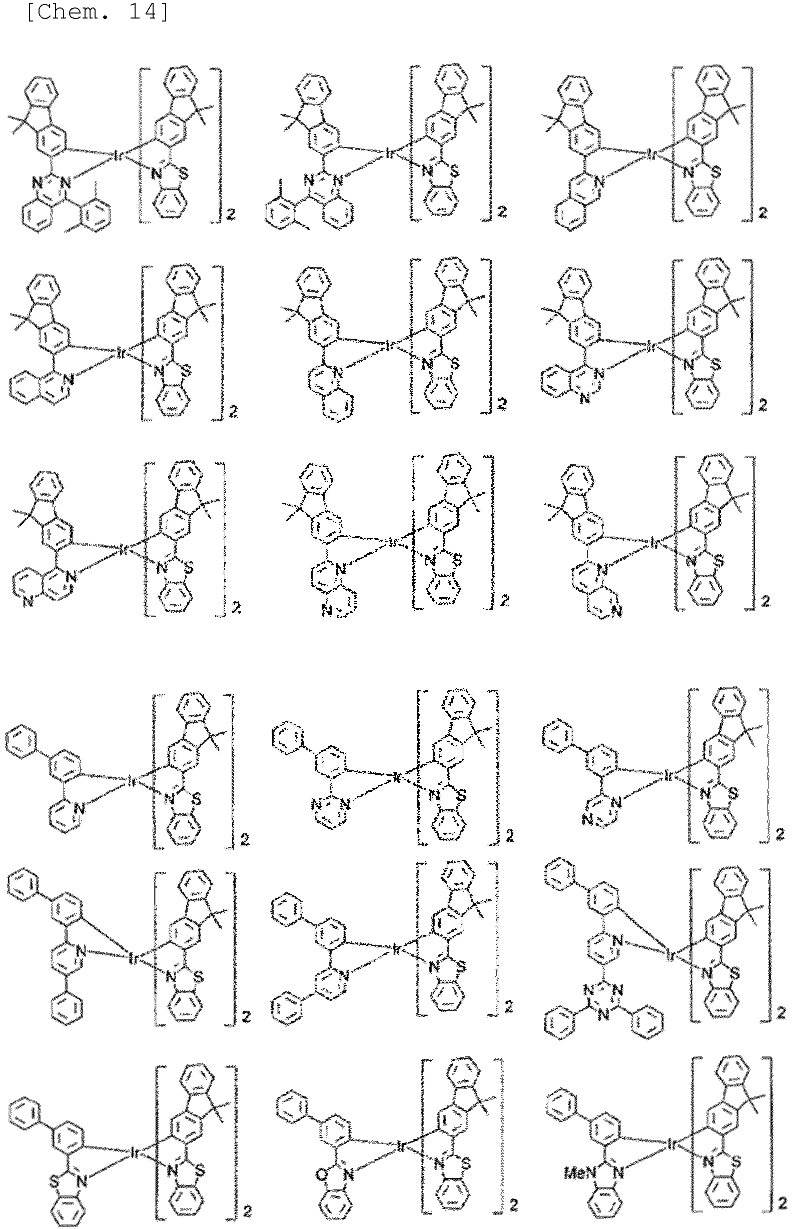

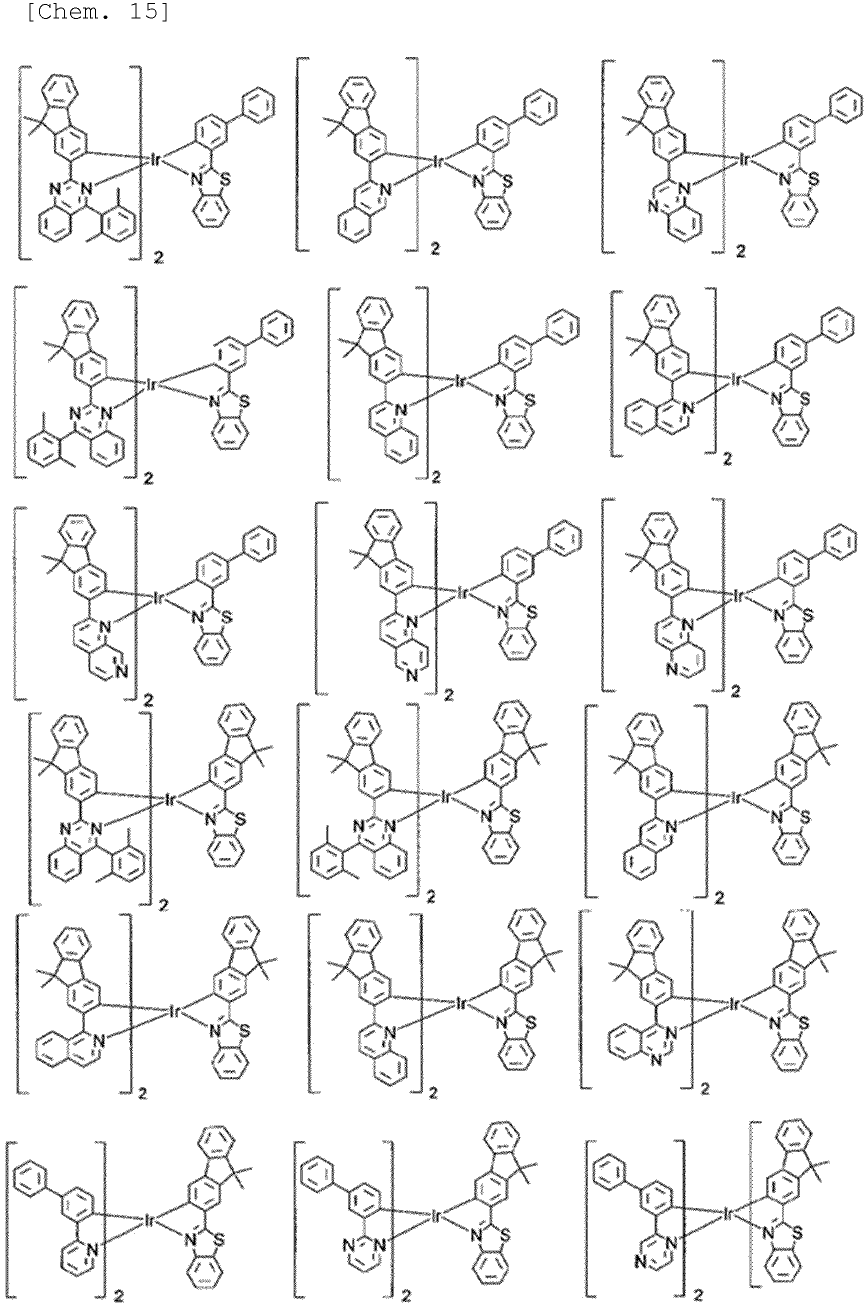

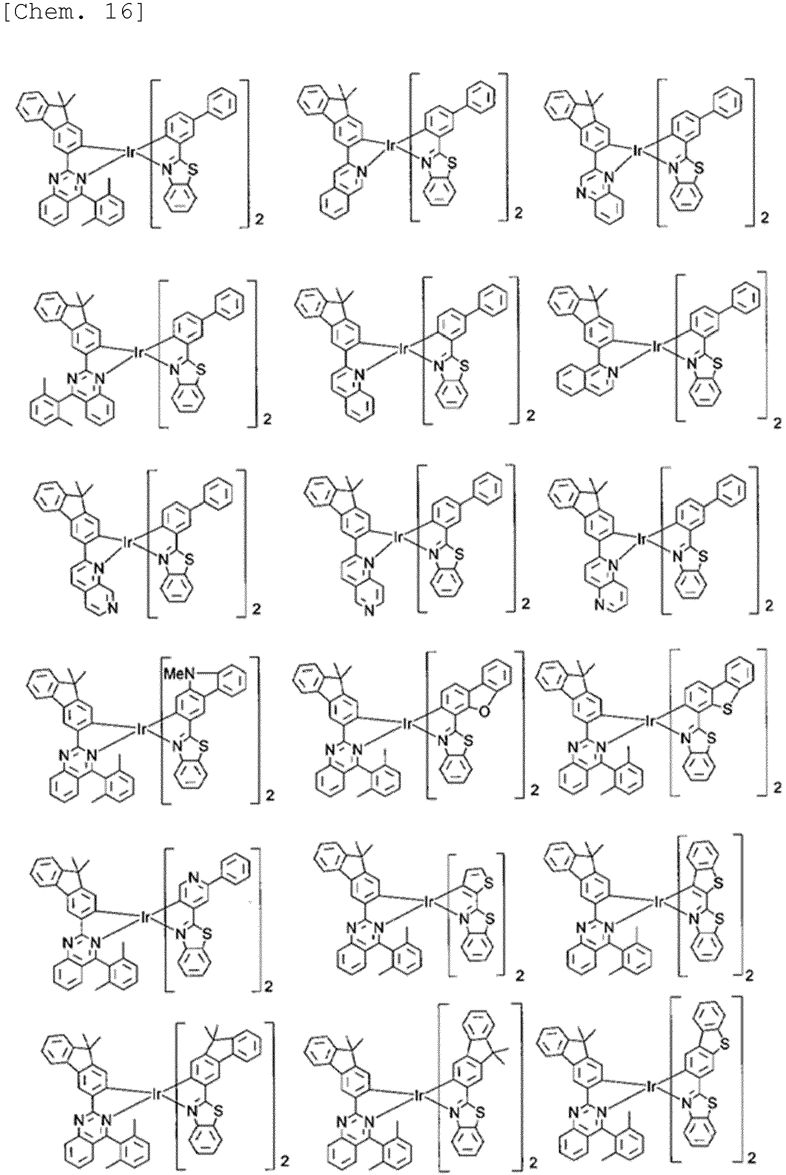

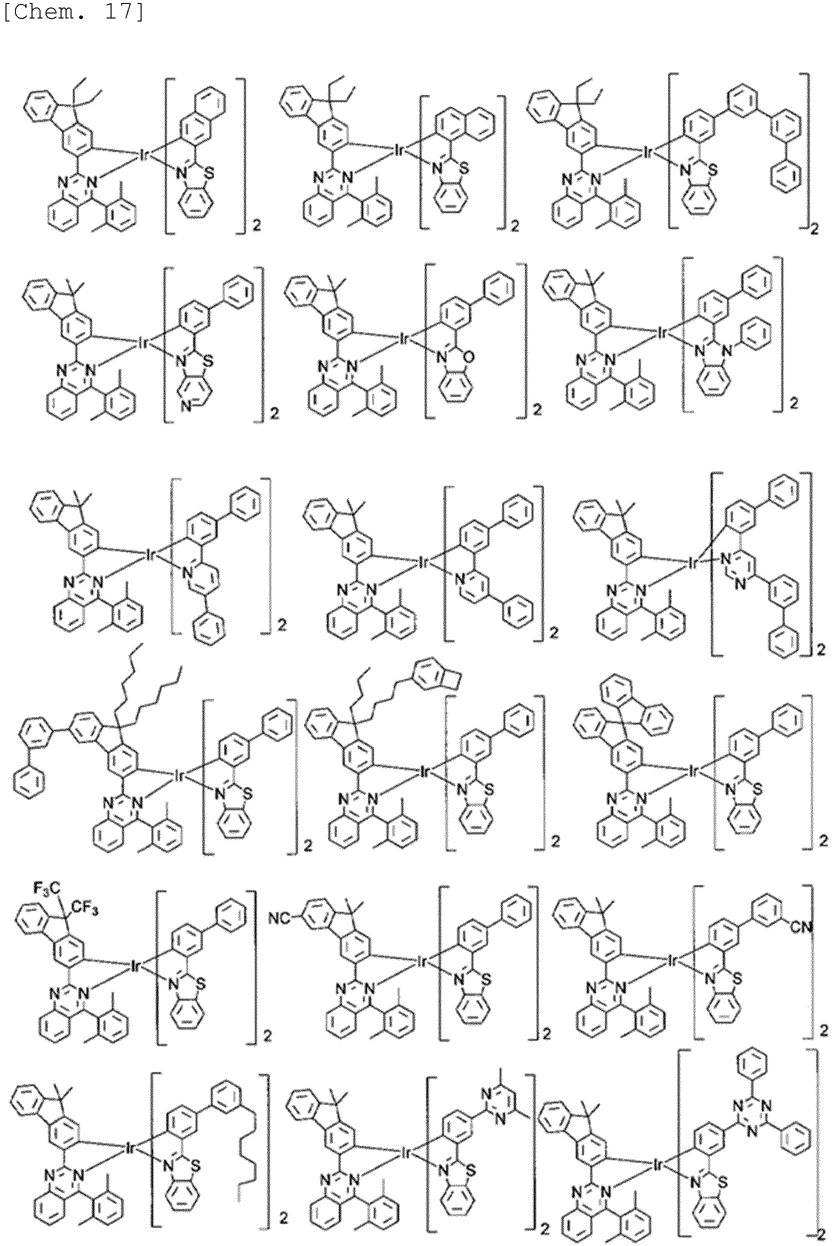

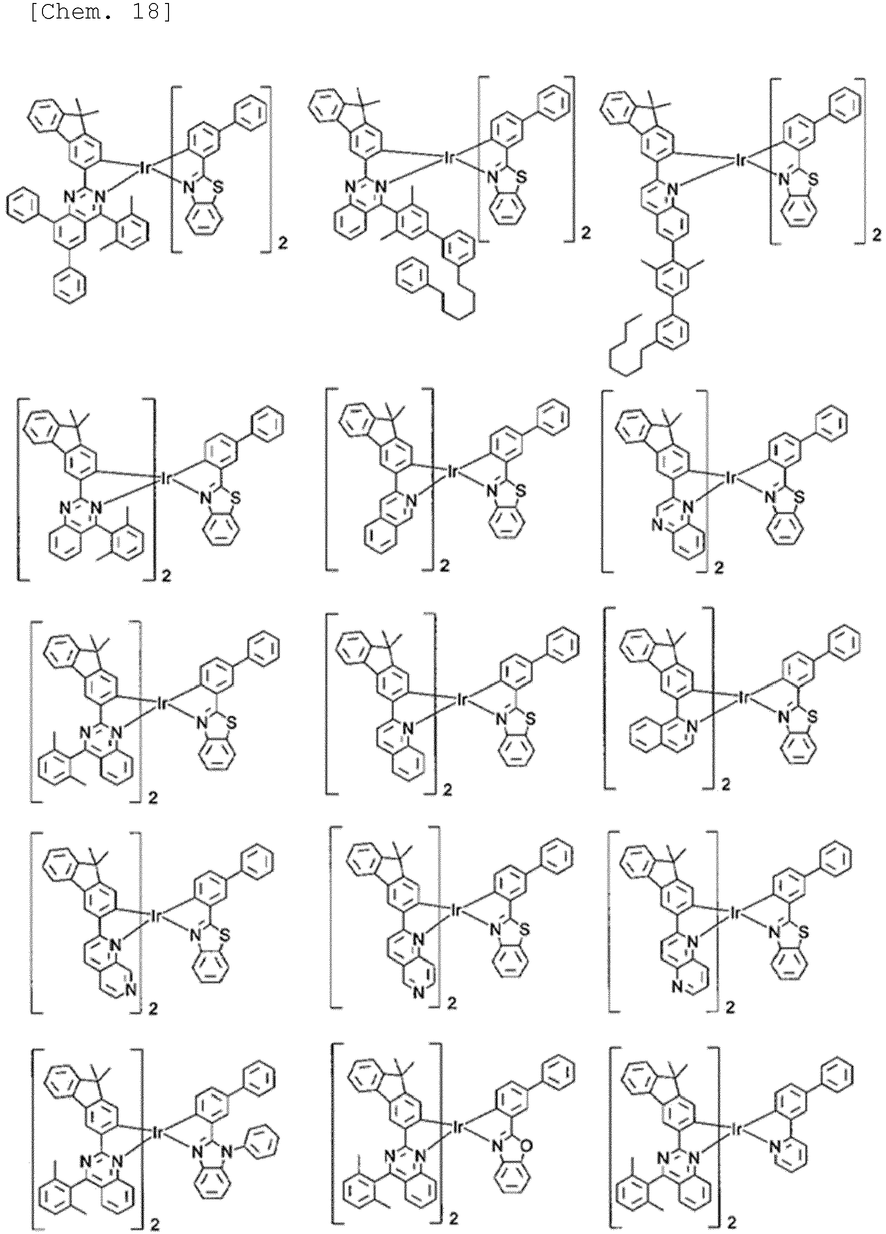

### <Novel iridium complex compound>

The present invention provides a novel iridium complex compound represented by formula (7) below. 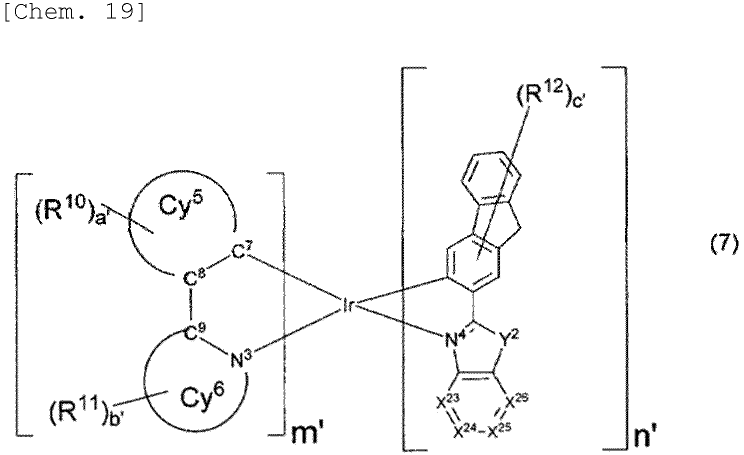 [in formula (7), Ir represents an iridium atom,
C⁷ to C⁹ represent carbon atoms, N³ and N⁴ represent nitrogen atoms,
a ring Cy⁵ represents an aromatic or heteroaromatic ring including the carbon atoms C⁷ and C⁸,
a ring Cy⁶ represents a heteroaromatic ring including the carbon atom C⁹ and the nitrogen atom N³,
X²³ to X²⁶ each independently represent an optionally substituted carbon atom or a nitrogen atom,
Y² represents an oxygen atom, a sulfur atom, or a selenium atom,
R¹⁰ to R¹² each independently represent a hydrogen atom or a substituent,
a' and b' represent maximum integer numbers of possible substituents on the rings Cy⁵ and Cy⁶, respectively, c' is 8, and
m' and n' each represent 1 or 2, m' + n' is 3].

In the iridium complex compound represented by formula (7), specific ligands are combined to be heteroleptic, whereby solvent solubility can be improved without the need for a long-chain alkyl group.

The present inventors have discovered that in formula (7), when an auxiliary ligand ring has a fluorene structure having R¹², the half-width of an emission spectrum is particularly large. In particular, the present inventors have discovered that this effect is particularly significant when the ring having the nitrogen atom N⁴ is a benzothiazole ring, irrespective of the type of the rings Cy⁵ and Cy⁶ serving as a major ligand.

While the reasons for this phenomenon are not fully understood, it is presumed that when the HOMO level on the auxiliary ligand side becomes shallow to deactivate electrons in an excited state, some of the electrons transit to the orbit on the auxiliary ligand side, and thus competition with a transition in the major ligand takes place, thus causing light emission due to multiple energy gaps.

### <Ring Cy⁵>

The ring Cy⁵ represents an aromatic or heteroaromatic ring including the carbon atoms C⁷ and C⁸ coordinating to the iridium atom. Specific examples and preferred ranges thereof are the same as those of the ring Cy³ in formula (1). Of these, the fluorene structure represented by formula (2) given as the ring Cy¹ in formula (1) is particularly preferred.

### <Ring Cy⁶>

The ring Cy⁶ represents a heteroaromatic ring including the carbon atom C⁹ and the nitrogen atom N³ coordinating to the iridium atom. Specific examples thereof include those shown as the heteroaromatic ring represented by the ring Cy³ in formula (1). Among them, the heteroaromatic rings given as the ring Cy² in formula (1) are particularly preferred.

### <X²³ to X²⁶>

X²³ to X²⁶ each independently represent a carbon atom or a nitrogen atom. In view of the ease of adjustment of the emission wavelength particularly to the red region and the ease of synthesis of a complex, the number of nitrogen atoms in X²³ to X²⁶ is preferably 0 or 1.

When X²³ to X²⁶ are carbon atoms, hydrogen atoms may be bonded to the carbon atoms, and the carbon atoms may each be substituted with any of substituents represented by R¹ to R⁴ described above, preferably with F, an alkyl group, an aromatic group, or a heteroaromatic group. In order not to impair the solubility of the iridium complex compound, the number of atoms constituting the benzothiazole ring including X²³ to X²⁶ is preferably 13 or less.

### <Y²>

Y² represents an oxygen atom, a sulfur atom, or a selenium atom. In view of the stability of the complex, Y² is preferably a sulfur atom.

### <R¹⁰ to R¹²>

R¹⁰ to R¹² represent a hydrogen atom or a substituent. R¹⁰ to R¹² are independent of each other and may be the same or different.

a' and b' represent maximum integer numbers of possible substituents on the rings Cy⁵ and Cy⁶, respectively, and c' is 8.

When there are pluralities of R¹⁰ to R¹², the pluralities of R¹⁰ to R¹² may each be the same or different.

For each of R¹⁰ to R¹², two or more adjacent ones may each be bonded together to form an aliphatic, aromatic, or heteroaromatic, monocyclic or fused ring.

Specific examples and preferred examples of substituents represented by R¹⁰ to R¹² are the same as the substituents represented by R¹ to R⁴ in formula (1).

### <Maximum emission wavelength>

The iridium complex compound of the present invention may have a longer emission wavelength. As an indicator of the length of an emission wavelength, the maximum emission wavelength measured by the following procedure is preferably 580 nm or more, more preferably 590 nm or more, still more preferably 600 nm or more, and preferably 700 nm or less, more preferably 680 nm or less. When the maximum emission wavelength is in this range, a preferred color of a red-light-emitting material suitable for an organic electroluminescent element tends to be exhibited.

### (Method of measuring maximum emission wavelength)

At normal temperature, the phosphorescence spectrum of a solution obtained by dissolving the iridium complex compound in 2-methyltetrahydrofuran at a concentration 1 × 10⁻⁴ mol/L or less is measured with a spectrophotometer (C9920-02 organic EL quantum yield spectrometer manufactured by Hamamatsu Photonics K.K.). The wavelength at a maximum intensity in the measured phosphorescence spectrum is used a maximum emission wavelength.

### <Method of synthesizing iridium complex compound>

### <Method of synthesizing ligand>

The ligands of the iridium complex compound of the present invention can be synthesized, for example, by a combination of known methods. In particular, the fluorene ring of the ring Cy¹ can be readily introduced, for example, by using, as a raw material, a compound having bromine, a - B(OH)₂ group, an acetyl group, or a carboxy group at the 2-position or the 3-position of a fluorene ring.

The ligand including the ring Cy¹ and the ring Cy² can be synthesized by further subjecting these raw materials to a known reaction such as Suzuki-Miyaura coupling reaction with halogenated quinoline or Friedlaender cyclization reaction with 2-formyl or acyl aniline or with acyl-amino pyridine in ortho position to each other (Chem. Rev. 2009, 109, 2652 or Organic Reactions, 28(2), 37-201).

### <Method of synthesizing iridium complex compound>

The iridium complex compound of the present invention can be synthesized, for example, by a combination of known methods. Details will be described below.

Examples of the method of synthesizing the iridium complex compound includes, but are not limited to, a method by which the target compound is obtained through a chloro-bridged iridium binuclear complex as expressed by reaction formula [A] below (M.G. Colombo, T.C. Brunold, T. Riedener, H.U. Gudel, Inorg. Chem., 1994, 33, 545-550), where a phenylpyridine ligand is used for ease of understanding, and a method by which the target compound is obtained after a binuclear complex is converted into a mononuclear complex by exchanging a chloro bridge for acetylacetonate as expressed by reaction formula [B] below (S. Lamansky, P. Djurovich, D. Murphy, F. Abdel-Razzaq, R. Kwong, I. Tsyba, M. Borz, B. Mui, R. Bau, M. Thompson, Inorg. Chem., 2001, 40, 1704-1711).

For example, conditions for the typical reaction expressed by reaction formula [A] below are as follows.

In the first stage, a chloro-bridged iridium binuclear complex is synthesized through a reaction of 2 equivalents of a first ligand and 1 equivalent of iridium chloride n-hydrate. Typically, a mixed solvent of 2-ethoxyethanol and water is used, but the reaction may be performed without a solvent or with another solvent. The reaction can be promoted by using the ligand in excess amount or using an additive such as a base. Instead of chlorine, other crosslinkable anionic ligands such as bromine can be used.

The reaction temperature is not particularly limited, and typically, it is preferably 0°C or more, more preferably 50°C or more, and preferably 250°C or less, more preferably 150°C or less. When the reaction temperature is in this range, the desired reaction alone tends to proceed with no by-products or decomposition reaction, thus achieving high selectivity. 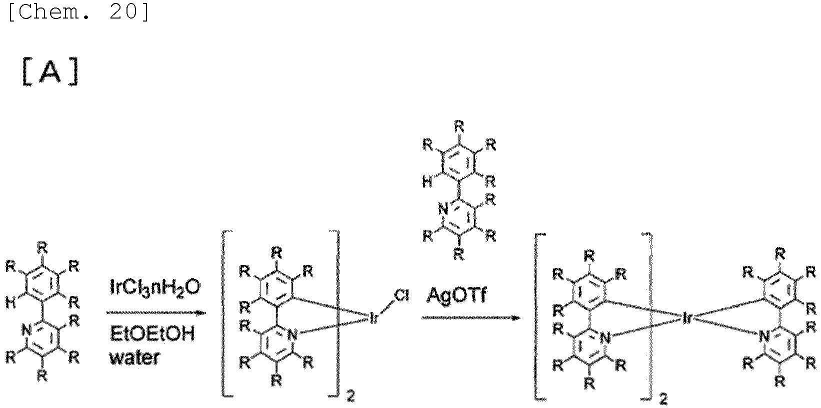 In the second stage, a halogen ion scavenger such as silver trifluoromethanesulfonate is added to bring the chloro-bridged iridium binuclear complex into contact with a second ligand, whereby the target complex is obtained. Typically, ethoxyethanol or diglyme is used as a solvent, but depending on the type of ligand, the reaction may be performed without a solvent, with another solvent, or with a mixture of two or more solvents. Although the halogen ion scavenger is not essential since the reaction may proceed without it, the addition of the scavenger is advantageous for increasing the reaction yield and selectively synthesizing a facial isomer having a higher quantum yield. The reaction temperature is typically, but not necessarily, in the range of 0°C to 250°C.

Typical reaction conditions expressed by reaction formula [B] below will be described.

The binuclear complex in the first stage can be synthesized in the same manner as in reaction formula [A].

In the second stage, the binuclear complex is allowed to react with 1 equivalent or more of a 1,3-dione compound such as acetylacetone and 1 equivalent or more of a basic compound, such as sodium carbonate, that can abstract active hydrogen of the 1,3-dione compound, to thereby convert into a mononuclear complex coordinated with a 1,3-dionate ligand. Typically, a solvent such as ethoxyethanol or dichloromethane that can dissolve the starting binuclear complex is used, but when the ligand is liquid, the reaction can be performed without a solvent. The reaction temperature is typically, but not necessarily, in the range of 0°C to 200°C.

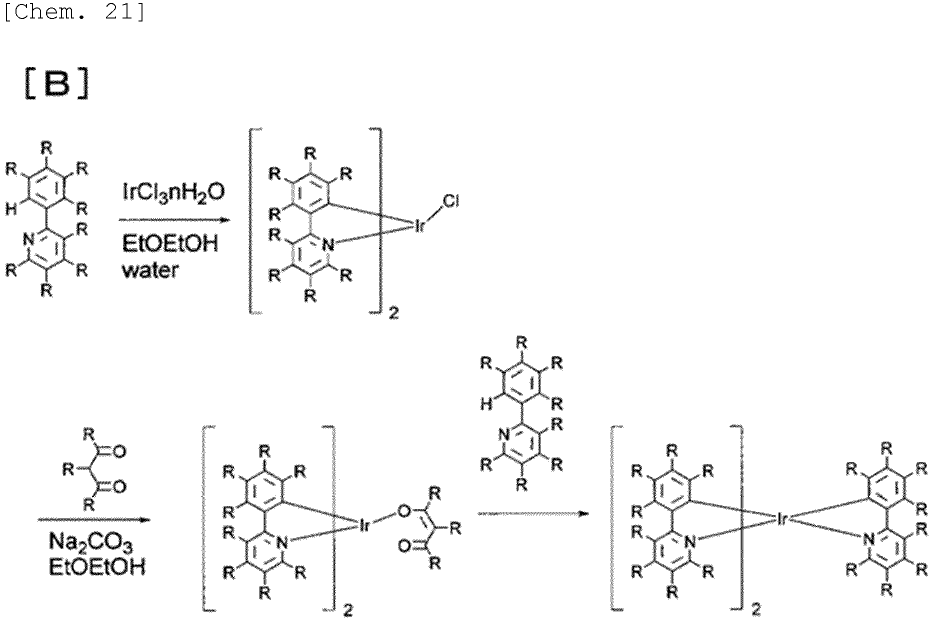

In the third stage, 1 equivalent or more of the second ligand is allowed to react. The type and amount of solvent is not particularly limited, and when the second ligand is liquid at a reaction temperature, the reaction may be performed without a solvent. The reaction temperature is also not particularly limited, but the reaction is often performed at a relatively high temperature of 100°C to 300°C because the reactivity is somewhat low. Thus, a high-boiling solvent such as glycerol is preferably used.

After the final reaction, purification is performed to remove unreacted raw materials, by-products, and the solvents. While a standard purification operation in synthetic organic chemistry can be used, purification by normal silica gel column chromatography is mainly performed as described in NPL above. As an eluent, hexane, heptane, dichloromethane, chloroform, ethyl acetate, toluene, methyl ethyl ketone, methanol, or a mixture thereof can be used. The purification may be performed more than once under different conditions. Purification operations such as other chromatography techniques (reverse phase silica gel chromatography, size exclusion chromatography, and paper chromatography), separate washing, reprecipitation, recrystallization, washing by powder suspension, and vacuum drying can be performed as required.

### <Applications for iridium complex compound>

The iridium complex compound of the present invention can be suitably used as a material used for an organic electroluminescent element, that is, a red-light-emitting material for an organic electroluminescent element, and can also be suitably used as a light-emitting material for an organic electroluminescent element and other light-emitting elements.

### [Iridium complex compound-containing composition]

The iridium complex compound of the present invention has high solvent solubility and thus is preferably used together with a solvent. A composition of the present invention containing the iridium complex compound of the present invention and a solvent (hereinafter also referred to as an "iridium complex compound-containing composition") will be described below.

The iridium complex compound-containing composition of the present invention contains the iridium complex compound of the present invention and a solvent. The iridium complex compound-containing composition of the present invention is typically used to form a layer or a film by a wet film-forming method, and in particular, the composition is preferably used to form an organic layer of an organic electroluminescent element. In particular, the organic layer is preferably a light-emitting layer.

The iridium complex compound-containing composition is preferably a composition for an organic electroluminescent element, and is particularly preferably used as a composition for light-emitting layer formation.

The content of the iridium complex compound of the present invention in the iridium complex compound-containing composition is typically 0.001 mass% or more, preferably 0.01 mass% or more, and typically 99.9 mass% or less, preferably 99 mass% or less. When the content of the iridium complex compound in the composition is in this range, holes and electrons are efficiently injected from adjacent layers (e.g., a hole transport layer and a hole blocking layer) into a light-emitting layer, thus leading to a low drive voltage.

The iridium complex compound of the present invention may be contained in the iridium complex compound-containing composition in the form of a single compound or a combination of two or more compounds.

The iridium complex compound-containing composition, when used, for example, for an organic electroluminescent element, may contain, in addition to the iridium complex compound of the present invention and the solvent, a charge transport compound used for an organic electroluminescent element, particularly, for a light-emitting layer.

The iridium complex compound-containing composition of the present invention, when used to form a light-emitting layer of an organic electroluminescent element, preferably contains the iridium complex compound of the present invention as a light-emitting material and another charge transport compound as a charge transport host material.

The solvent contained in the iridium complex compound-containing composition of the present invention is a volatile liquid component used to form a layer containing the iridium complex compound by wet film-formation.

Since the iridium complex compound of the present invention serving as a solute has high solvent solubility, the solvent is not particularly limited as long as it is an organic solvent in which the charge transport compounds described later are dissolved well.

Examples of preferred solvents include alkanes such as n-decane, cyclohexane, ethylcyclohexane, decalin, and bicyclohexane; aromatic hydrocarbons such as toluene, xylene, mesitylene, phenylcyclohexane, and tetralin; halogenated aromatic hydrocarbons such as chlorobenzene, dichlorobenzene, and trichlorobenzene; aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole, 2,4-dimethylanisole, and diphenyl ether; aromatic esters such as phenyl acetate, phenyl propionate, methyl benzoate, ethyl benzoate, propyl benzoate, and n-butyl benzoate; alicyclic ketones such as cyclohexanone, cyclooctanone, and fenchone; alicyclic alcohols such as cyclohexanol and cyclooctanol; aliphatic ketones such as methyl ethyl ketone and dibutyl ketone; aliphatic alcohols such as butanol and hexanol; and aliphatic ethers such as ethylene glycol dimethyl ether, ethylene glycol diethyl ether, and propylene glycol-1-monomethyl ether acetate (PGMEA).

Of these, alkanes and aromatic hydrocarbons are preferred. In particular, phenylcyclohexane has a viscosity and boiling point preferred for a wet film-forming process.

These solvents may be used alone, or two or more of them may be used in any combination and ratio.

The boiling point of the solvent used is typically 80°C or more, preferably 100°C or more, more preferably 120°C or more, and typically 270°C or less, preferably 250°C or less, more preferably 230°C or less. Below this range, the solvent may evaporate from the composition during wet film-formation, resulting in unstable film formation.

The content of the solvent in the iridium complex compound-containing composition is preferably 1 mass% or more, more preferably 10 mass% or more, particularly preferably 50 mass% or more, and preferably 99.99 mass% or less, more preferably 99.9 mass% or less, particularly preferably 99 mass% or less. The thickness of the light-emitting layer is typically about 3 to 200 nm, and when the content of the solvent is below this lower limit, the viscosity of the composition may be excessively high, resulting in low workability in film formation. When the content of the solvent is above this upper limit, the thickness of a film obtained by removing the solvent after film formation tends to be insufficient, thus resulting in unsuccessful film formation.

As the other charge transport compound that may be contained in the iridium complex compound-containing composition of the present invention, a compound conventionally used as a material for an organic electroluminescent element can be used. Examples include pyridine, carbazole, naphthalene, perylene, pyrene, anthracene, chrysene, naphthacene, phenanthrene, coronene, fluoranthene, benzophenanthrene, fluorene, acetonaphthofluoranthene, coumarin, p-bis(2-phenylethenyl)benzene, derivatives thereof, quinacridone derivatives, DCM (4-(dicyanomethylene)-2-methyl-6-(p-dimethylaminostyryl)-4H-pyran) compounds, benzopyran derivatives, rhodamine derivatives, benzothioxanthene derivatives, azabenzothioxanthene, arylamino-substituted fused aromatic ring compounds, and arylamino-substituted styryl derivatives.

These may be used alone, or two or more of them may be used in any combination and ratio.

Relative to 1 part by mass of the iridium complex compound of the present invention in the iridium complex compound-containing composition, the content of the other charge transport compound in the iridium complex compound-containing composition is typically 1,000 parts by mass or less, preferably 100 parts by mass or less, still more preferably 50 parts by mass or less, and typically 0.01 parts by mass or more, preferably 0.1 parts by mass or more, still more preferably 1 part by mass or more.

The iridium complex compound-containing composition of the present invention may optionally further contain other compounds in addition to the above-described compounds. For example, other solvents may be contained in addition to the above-described solvents. Examples of the other solvents include amides such as N,N-dimethylformamide and N,N-dimethylacetamide, and dimethylsulfoxide. These may be used alone, or two or more of them may be used in any combination and ratio.

### [Organic electroluminescent element]

An organic electroluminescent element of the present invention contains the iridium complex compound of the present invention.

The organic electroluminescent element of the present invention preferably includes a substrate, an anode and a cathode on the substrate, and one or more organic layers between the anode and the cathode, and at least one of the organic layers contains the iridium complex compound of the present invention. The organic layers include a light-emitting layer.

The organic layer containing the iridium complex compound of the present invention is more preferably a layer formed using the composition of the present invention, still more preferably a layer formed by a wet film-forming method. The layer formed by a wet film-forming method is preferably a light-emitting layer.

In the present invention, the term "wet film-forming method" refers to a method of forming a film in which film formation, that is, application is performed by a wet method, such as a spin coating method, a dip coating method, a die coating method, a bar coating method, a blade coating method, a roll coating method, a spray coating method, a capillary coating method, an ink-jet method, a nozzle printing method, a screen printing method, a gravure printing method, or a flexographic printing method, to form a film and the film formed by any of these methods is dried.

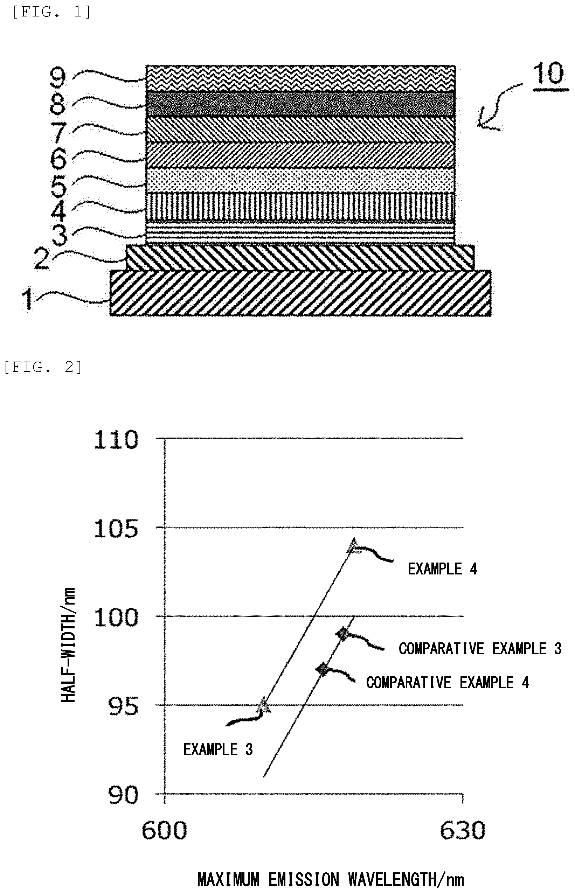

Fig. 1 is a schematic sectional view of an exemplary structure suitable for an organic electroluminescent element 10 of the present invention. In Fig. 1, reference numeral 1 denotes a substrate, reference numeral 2 an anode, reference numeral 3 a hole injection layer, reference numeral 4 a hole transport layer, reference numeral 5 a light-emitting layer, reference numeral 6 a hole blocking layer, reference numeral 7 an electron transport layer, reference numeral 8 an electron injection layer, and reference numeral 9 a cathode.

Materials used for the structure may be known materials and are not particularly limited. For each layer, an exemplary material and production method will be described below. It is intended that the content of any patent publications and journals cited herein may be appropriately applied or used within the common knowledge of a person skilled in the art.

### <Substrate 1>

A substrate 1 serves as a support for the organic electroluminescent element and is typically, for example, a quartz or glass plate, a metal plate or metal foil, or a plastic film or sheet. In particular, the substrate 1 is preferably a glass plate or a transparent synthetic resin plate made of, for example, polyester, polymethacrylate, polycarbonate, or polysulfone. The substrate 1 is preferably made of a material with high gas barrier properties to prevent deterioration of the organic electroluminescent element due to ambient air. In particular, when a material with low gas barrier properties, such as a synthetic resin substrate, is used, a dense silicon oxide film or the like is preferably disposed on at least one surface of the substrate 1 to improve the gas barrier properties.

### <Anode 2>

An anode 2 functions to inject holes into a layer on the light-emitting layer side. The anode 2 is typically made of a metal such as aluminum, gold, silver, nickel, palladium, or platinum; a metal oxide such as indium and/or tin oxide; a halogenated metal such as copper iodide; a conductive polymer such as carbon black, poly(3-methylthiophene), polypyrrole, or polyaniline; or the like.

The anode 2 is typically formed by a dry method such as a sputtering method or a vacuum deposition method. When the anode 2 is formed by using, for example, fine particles of a metal such as silver, fine particles of copper iodide or the like, carbon black, fine particles of a conductive metal oxide, or fine powder of a conductive polymer, a dispersion of such a material in an appropriate binder resin solution may be applied to the substrate to form the anode 2. In the case of a conductive polymer, the anode 2 can be formed by forming a thin film directly on a substrate through electrolytic polymerization or applying the conductive polymer on a substrate (Appl. Phys. Lett., vol. 60, p. 2711, 1992) .

The anode 2 typically has a single-layer structure but may have a multilayer structure as appropriate. When the anode 2 has a multilayer structure, a different conductive material may be stacked on a first anode layer.

The thickness of the anode 2 may be determined according to, for example, the transparency required and the material used. When particularly high transparency is required, the thickness is preferably such that the visible light transmittance of the anode 2 is 60% or more, more preferably 80% or more. The thickness of the anode 2 is typically 5 nm or more, preferably 10 nm or more, and typically 1,000 nm or less, preferably 500 nm or less.

When transparency is not required, the anode 2 may have any thickness according to, for example, the strength required. In this case, the anode 2 may have the same thickness as the substrate 1.

When a film is formed on a surface of the anode 2, it is preferable to perform, before the film formation, a treatment with ultraviolet rays + ozone, oxygen plasma, argon plasma, or the like to thereby remove impurities on the anode and adjust the ionization potential thereof to improve hole injection ability.

### <Hole injection layer 3>

The layer that functions to transport holes from the anode 2 side to the light-emitting layer 5 side is typically called a hole injection-transport layer or a hole transport layer. When there are two or more layers that function to transport holes from the anode 2 side to the light-emitting layer 5 side, the layer closer to the anode 2 side may be called a hole injection layer 3. The hole injection layer 3 is preferably used to enhance the function of transporting holes from the anode 2 to the light-emitting layer 5 side. When the hole injection layer 3 is used, the hole injection layer 3 is typically formed on the anode 2.

The thickness of the hole injection layer 3 is typically 1 nm or more, preferably 5 nm or more, and typically 1,000 nm or less, preferably 500 nm or less.

The hole injection layer 3 may be formed by a vacuum deposition method or a wet film-forming method. In terms of high film formability, the hole injection layer 3 is preferably formed by a wet film-forming method.

The hole injection layer 3 preferably contains a hole-transporting compound, more preferably contains a hole-transporting compound and an electron-accepting compound. Furthermore, the hole injection layer 3 preferably contains a cation radical compound, particularly preferably contains a cation radical compound and a hole-transporting compound.

### (Hole-transporting compound)

A composition for hole injection layer formation typically contains a hole-transporting compound that will form the hole injection layer 3.

In the case of a wet film-forming method, typically, a solvent is further contained. The composition for hole injection layer formation preferably has a high hole transport ability and can efficiently transport injected holes. Thus, the composition preferably has high hole mobility and is less likely to generate trapping impurities, for example, during production or use. In addition, the composition preferably has high stability, a low ionization potential, and high transparency to visible light. Particularly when the hole injection layer 3 is in contact with the light-emitting layer 5, the composition preferably does not quench light emitted from the light-emitting layer 5 and does not form an exciplex together with the light-emitting layer 5 to reduce light emission efficiency.

The hole-transporting compound is preferably a compound having an ionization potential of 4.5 eV to 6.0 eV from the viewpoint of a barrier to charge injection from the anode 2 to the hole injection layer 3. Examples of the hole-transporting compound include aromatic amine compounds, phthalocyanine compounds, porphyrin compounds, oligothiophene compounds, polythiophene compounds, benzylphenyl compounds, compounds having tertiary amines connected to each other through a fluorene group, hydrazone compounds, silazane compounds, and quinacridone compounds.

Among the above exemplary compounds, aromatic amine compounds are preferred, and aromatic tertiary amine compounds are particularly preferred, in terms of amorphous properties and visible light transmittance. Aromatic tertiary amine compounds are compounds having an aromatic tertiary amine structure and also include compounds having a group derived from an aromatic tertiary amine.

The type of aromatic tertiary amine compound is not particularly limited, but it is preferable to use a polymer compound having a weight average molecular weight of 1,000 or more and 1,000,000 or less (polymerized compound having a series of repeating units) because uniform light emission is readily provided due to the surface-smoothing effect. Examples of preferred aromatic tertiary amine polymer compounds include a polymer compound having a repeating unit represented by formula (I) below.

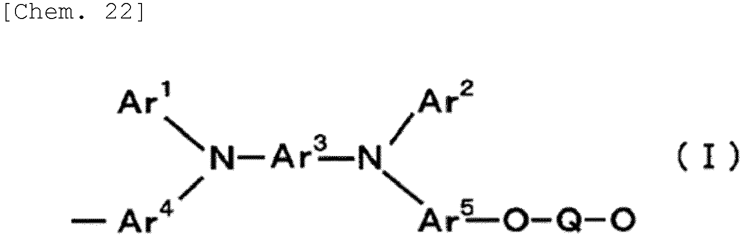

(In formula (I), Ar¹ and Ar² each independently represent an optionally substituted aromatic group or an optionally substituted heteroaromatic group. Ar³ to Ar⁵ each independently represent an optionally substituted aromatic group or an optionally substituted heteroaromatic group. Q represents a linking group selected from the group of linking groups given below. Among Ar¹ to Ar⁵, two groups bonded to the same N atom may be bonded together to form a ring.

The linking groups are given below.

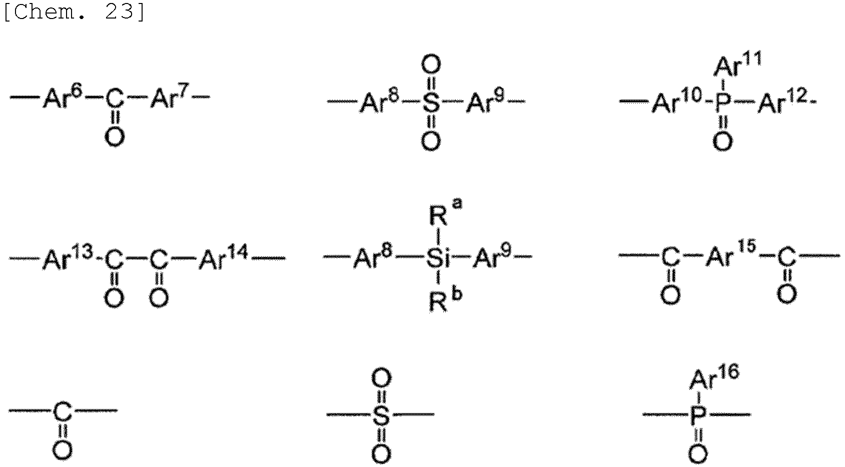

(In each of the above formulae, Ar⁶ to Ar¹⁶ each independently represent an optionally substituted aromatic group or an optionally substituted heteroaromatic group. R^{a} to R^{b} each independently represent a hydrogen atom or a substituent.)

In terms of solubility, heat resistance, and hole injection transport ability of the polymer compound, the aromatic groups and the heteroaromatic groups represented by Ar¹ to Ar¹⁶ are each preferably a group derived from a benzene ring, a naphthalene ring, a phenanthrene ring, a thiophene ring, or a pyridine ring, more preferably a group derived from a benzene ring or a naphthalene ring.

Specific examples of the aromatic tertiary amine polymer compound having the repeating unit represented by formula (I) include compounds described in International Publication No. 2005/089024.

### (Electron-accepting compound)

The hole injection layer 3 preferably contains an electron-accepting compound because the electric conductivity of the hole injection layer 3 can be improved through oxidation of the hole-transporting compound.

The electron-accepting compound is preferably a compound having oxidizing power and capable of accepting one electron from the above hole-transporting compound. Specifically, a compound having an electron affinity of 4 eV or more is preferred, and a compound having an electron affinity of 5 eV or more is more preferred.

Examples of such electron-accepting compounds include one or more compounds selected from the group consisting of triaryl boron compounds, halogenated metals, Lewis acids, organic acids, onium salts, salts of an arylamine and a halogenated metal, and salts of an arylamine and a Lewis acid. Specific examples include onium salts with a substituted organic group, such as 4-isopropyl-4'-methyldiphenyliodonium tetrakis(pentafluorophenyl)borate and triphenylsulfonium tetrafluoroborate (International Publication No. 2005/089024); high-valent inorganic compounds such as iron (III) chloride (Japanese Unexamined Patent Application Publication No. 11-251067) and ammonium peroxodisulfate; cyano compounds such as tetracyanoethylene; aromatic boron compounds such as tris(pentafluorophenyl)borane (Japanese Unexamined Patent Application Publication No. 2003-31365); fullerene derivatives; and iodine.

### (Cation radical compound)

The cation radical compound is preferably an ionic compound composed of a cation radical, which is a chemical species resulting from the removal of one electron from a hole-transporting compound, and a counter anion. When the cation radical is derived from a hole-transporting polymer compound, the cation radical has a structure resulting from the removal of one electron from the repeating unit of the polymer compound.

The cation radical is preferably a chemical species that results from the removal of one electron from any of the compounds listed above as a hole-transporting compound. A chemical species that results from the removal of one electron from a compound preferred as a hole-transporting compound is suitable in terms of, for example, amorphous properties, visible light transmittance, heat resistance, and solubility.

The cation radical compound can be produced by mixing the hole-transporting compound and the electron-accepting compound. The mixing of the hole-transporting compound and the electron-accepting compound causes electrons to migrate from the hole-transporting compound to the electron-accepting compound, as a result of which a cationic compound composed of a cation radical of the hole-transporting compound and a counter anion is produced.

Polymer compound-derived cation radical compounds such as PEDOT/PSS (Adv. Mater., 2000, vol. 12, p. 481) and emeraldine hydrochloride (J. Phys. Chem., 1990, vol. 94, p. 7716) are produced also through oxidation polymerization (dehydrogenation polymerization).

As used herein, oxidation polymerization refers to oxidizing a monomer, in an acidic solution, chemically using peroxodisulfate or the like or electrochemically. In the case of oxidation polymerization (dehydrogenation polymerization), a monomer is oxidized to form a polymer, while one electron is removed from the repeating unit of the polymer to produce a cation radical, with an anion derived from an acidic solution serving as a counter anion.

### (Formation of hole injection layer 3 by wet film-forming method)

When the hole injection layer 3 is formed by a wet film-forming method, it is typically formed by mixing a material that will form the hole injection layer 3 with an appropriate solvent (a solvent for a hole injection layer) to prepare a composition for film formation (composition for hole injection layer formation), applying the composition for hole injection layer formation onto a layer (typically, the anode 2) corresponding to an underlayer of the hole injection layer 3 by a wet film-forming method to form a film, and drying the film. The drying of the formed film can be performed in the same manner as the drying in the formation of the light-emitting layer 5 by a wet film-forming method.

The concentration of the hole-transporting compound in the composition for hole injection layer formation, although not particularly limited as long as the effects of the present invention are not greatly impaired, is preferably low in terms of thickness uniformity, and is preferably high in terms of defect resistance of the hole injection layer 3. The concentration of the hole-transporting compound in the composition for hole injection layer formation is preferably 0.01 mass% or more, more preferably 0.1 mass% or more, particularly preferably 0.5 mass% or more, and preferably 70 mass% or less, more preferably 60 mass% or less, particularly preferably 50 mass% or less.

Examples of the solvent include ether solvents, ester solvents, aromatic hydrocarbon solvents, and amide solvents.

Examples of ether solvents include aliphatic ethers such as ethylene glycol dimethyl ether, ethylene glycol diethyl ether, and propylene glycol-1-monomethyl ether acetate (PGMEA) and aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole, and 2,4-dimethylanisole.

Examples of ester solvents include aromatic esters such as phenyl acetate, phenyl propionate, methyl benzoate, ethyl benzoate, propyl benzoate, and n-butyl benzoate.

Examples of aromatic hydrocarbon solvents include toluene, xylene, cyclohexylbenzene, 3-isopropylbiphenyl, 1,2,3,4-tetramethylbenzene, 1,4-diisopropylbenzene, and methylnaphthalene.

Examples of amide solvents include N,N-dimethylformamide and N,N-dimethylacetamide.

Other solvents such as dimethylsulfoxide can also be used.

The formation of the hole injection layer 3 by a wet film-forming method is typically performed by preparing the composition for hole injection layer formation, then applying the composition onto a layer (typically, the anode 2) corresponding to an underlayer of the hole injection layer 3 to form a film, and drying the film. In forming the hole injection layer 3, typically, the coating film is dried, for example, by heating or vacuum drying after the film formation.

### (Formation of hole injection layer 3 by vacuum deposition method)

When the hole injection layer 3 is formed by a vacuum deposition method, it is typically formed as described below. One or more of the constituent materials (e.g., the hole-transporting compound and the electron-accepting compound) of the hole injection layer 3 are placed in a crucible mounted in a vacuum chamber (when two or more materials are used, they are typically placed in different crucibles), and the vacuum chamber is evacuated with a vacuum pump to about 10⁻⁴ Pa. Thereafter, the crucible is heated (when two or more materials are used, the crucibles are typically each heated), and the material in the crucible is evaporated while controlling the amount of evaporation (when two or more materials are used, the materials are typically independently evaporated while controlling the amount of evaporation) to form the hole injection layer 3 on the anode 2 on a substrate placed so as to face the crucible. When two or more materials are used, a mixture thereof may be placed in a crucible, and heated and evaporated to form the hole injection layer 3.

The degree of vacuum during the deposition is not particularly limited as long as the effects of the present invention are not greatly impaired, and is typically 0.1 × 10⁻⁶ Torr (0.13 × 10⁻⁴ Pa) or more and 9.0 × 10⁻⁶ Torr (12.0 × 10⁻⁴ Pa) or less. The rate of deposition is not particularly limited as long as the effects of the present invention are not greatly impaired, and is typically 0.1 Å/s or more and 5.0 Å/s or less. The film formation temperature during the deposition is not particularly limited as long as the effects of the present invention are not greatly impaired, and is preferably 10°C or more and 50°C or less.

### <Hole transport layer 4>

A hole transport layer 4 is a layer that functions to transport holes from the anode 2 side to the light-emitting layer 5 side. Although the hole transport layer 4 is not essential in the organic electroluminescent element of the present invention, this layer is preferably provided in order to enhance the function of transporting holes from the anode 2 to the light-emitting layer 5. When the hole transport layer 4 is provided, the hole transport layer 4 is typically formed between the anode 2 and the light-emitting layer 5. When the hole injection layer 3 is present, the hole transport layer 4 is formed between the hole injection layer 3 and the light-emitting layer 5.

The thickness of the hole transport layer 4 is typically 5 nm or more, preferably 10 nm or more, and typically 300 nm or less, preferably 100 nm or less.

The hole transport layer 4 may be formed by a vacuum deposition method or a wet film-forming method. In terms of high film formability, the hole transport layer 4 is preferably formed by a wet film-forming method.

The hole transport layer 4 typically contains a hole-transporting compound that will form the hole transport layer 4. Specific examples of the hole-transporting compound contained in the hole transport layer 4 include aromatic diamines which contain two or more tertiary amines and in which two or more fused aromatic rings are substituted with nitrogen atoms, such as 4,4'-bis[N-(1-naphthyl)-N-phenylamino]biphenyl (Japanese Unexamined Patent Application Publication No. 5-234681); aromatic amine compounds having a starburst structure, such as 4,4',4"-tris(1-naphthylphenylamino)triphenylamine (J. Lumin., vols. 72-74, p. 985, 1997); aromatic amine compounds composed of a tetramer of triphenylamine (Chem. Commun., p. 2175, 1996); spiro compounds such as 2,2',7,7'-tetrakis-(diphenylamino)-9,9'-spirobifluorene (Synth. Metals, vol. 91, p. 209, 1997); and carbazole derivatives such as 4,4'-N,N'-dicarbazolebiphenyl. Polyvinylcarbazole, polyvinyltriphenylamine (Japanese Unexamined Patent Application Publication No. 7-53953), polyarylene ether sulfone containing tetraphenylbenzidine (Polym. Adv. Tech., vol. 7, p. 33, 1996), and the like can also be preferably used.

### (Formation of hole transport layer 4 by wet film-forming method)

When the hole transport layer 4 is formed by a wet film-forming method, it is typically formed as in the case where the hole injection layer 3 is formed by a wet film-forming method, except that the composition for hole injection layer formation is replaced with a composition for hole transport layer formation.

When the hole transport layer 4 is formed by a wet film-forming method, the composition for hole transport layer formation typically further contains a solvent. The solvent used for the composition for hole transport layer formation may be the same solvent as used for the composition for hole injection layer formation.

The concentration of the hole-transporting compound in the composition for hole transport layer formation may be in the same range as that of the concentration of the hole-transporting compound in the composition for hole injection layer formation.

The formation of the hole transport layer 4 by a wet film-forming method can be performed in the same manner as the formation of the hole injection layer 3.

### (Formation of hole transport layer 4 by vacuum deposition method)

Also when the hole transport layer 4 is formed by a vacuum deposition method, it can be typically formed as in the case where the hole injection layer 3 is formed by a vacuum deposition method, except that the constituent materials of the hole injection layer 3 are replaced with constituent materials of the hole transport layer 4. The film formation conditions, including the degree of vacuum during the deposition, the rate of deposition, and the temperature, may be the same as the conditions for the vacuum deposition of the hole injection layer 3.

### <Light-emitting layer 5>

The light-emitting layer 5 is a layer that functions to emit light upon being excited by recombination of holes injected from the anode 2 and electrons injected from a cathode 9 in response to an electric field applied between the pair of electrodes.

The light-emitting layer 5 is a layer formed between the anode 2 and the cathode 9. When the hole injection layer 3 is present on the anode 2, the light-emitting layer 5 is formed between the hole injection layer 3 and the cathode 9, and when the hole transport layer 4 is present on the anode 2, the light-emitting layer 5 is formed between the hole transport layer 4 and the cathode 9.

The thickness of the light-emitting layer 5, although not particularly limited as long as the effects of the present invention are not greatly impaired, is preferably large to prevent defects of the film, and is preferably small to help achieve a low drive voltage. The thickness of the light-emitting layer 5 is preferably 3 nm or more, more preferably 5 nm or more, and preferably 200 nm or less, more preferably 100 nm or less.

The light-emitting layer 5 contains at least a material having light-emitting properties (light-emitting material), and preferably also contains a material having charge transport ability (charge-transporting material). It is only required that at least one of the light-emitting layers contain the iridium complex compound of the present invention as a light-emitting material, and other light-emitting materials may be used as appropriate. Light-emitting materials other than the iridium complex compound of the present invention will be described below in detail.

### (Light-emitting material)

The light-emitting material is not particularly limited as long as it emits light at a desired emission wavelength and the effects of the present invention are not impaired, and a known light-emitting material can be used. The light-emitting material may be a fluorescent material or a phosphorescent material, and is preferably a material with good light emission efficiency, preferably a phosphorescent material from the viewpoint of internal quantum efficiency.

Examples of the fluorescent material include the following materials.

Examples of fluorescent materials that provide blue-light emission (blue fluorescent materials) include naphthalene, perylene, pyrene, anthracene, coumarin, chrysene, p-bis(2-phenylethenyl)benzene, and derivatives thereof.

Examples of fluorescent materials that provide green-light emission (green fluorescent materials) include quinacridone derivatives, coumarin derivatives, and aluminum complexes such as Al(C₉H₆NO)₃.

Examples of fluorescent materials that provide yellow-light emission (yellow fluorescent materials) include rubrene and perimidone derivatives.

Examples of fluorescent materials that provide red-light emission (red fluorescent materials) include DCM (4-(dicyanomethylene)-2-methyl-6-(p-dimethylaminostyryl)-4H-pyran) compounds, benzopyran derivatives, rhodamine derivatives, benzothioxanthene derivatives, and azabenzothioxanthene.

Examples of the phosphorescent material include organometallic complexes containing a metal selected from groups 7 to 11 of the long-form periodic table (hereinafter, when the term "the periodic table" is used, it refers to the long-form periodic table, unless otherwise specified). Preferred examples of the metal selected from groups 7 to 11 of the periodic table include ruthenium, rhodium, palladium, silver, rhenium, osmium, iridium, platinum, and gold.

The ligand of such an organometallic complex is preferably a ligand in which a (hetero)aryl group is linked to pyridine, pyrazole, phenanthroline, or the like, such as a (hetero)arylpyridine ligand or a (hetero)arylpyrazole ligand, particularly preferably a phenylpyridine ligand or a phenylpyrazole ligand. Here, (hetero)aryl means an aryl group or a heteroaryl group.

Specific examples of preferred phosphorescent materials include phenylpyridine complexes such as tris(2-phenylpyridine)iridium, tris(2-phenylpyridine)ruthenium, tris(2-phenylpyridine)palladium, bis(2-phenylpyridine)platinum, tris(2-phenylpyridine)osmium, and tris(2-phenylpyridine)rhenium; and porphyrin complexes such as platinum octaethylporphyrin, platinum octaphenylporphyrin, palladium octaethylporphyrin, and palladium octaphenylporphyrin.

Examples of polymeric light-emitting materials include polyfluorene materials such as poly(9,9-dioctylfluorene-2,7-diyl), poly[(9,9-dioctylfluorene-2,7-diyl)-co-(4,4'-(N-(4-sec-butylphenyl))diphenylamine)], and poly[(9,9-dioctylfluorene-2,7-diyl)-co-(1,4-benzo-2{2,1'-3}-triazole)]; and polyphenylenevinylene materials such as poly[2-methoxy-5-(2-ethylhexyloxy)-1,4-phenylenevinylene].

### (Charge-transporting material)

The charge-transporting material is a material having a positive charge (hole) or negative charge (electron) transport ability and may be any known material as long as the effects of the present invention are not impaired.

The charge-transporting material may be, for example, a compound conventionally used for the light-emitting layer 5 of an organic electroluminescent element, and, in particular, is preferably a compound used as a host material of the light-emitting layer 5.

Specific examples of the charge-transporting material include the compounds exemplified as the hole-transporting compound of the hole injection layer 3, such as aromatic amine compounds, phthalocyanine compounds, porphyrin compounds, oligothiophene compounds, polythiophene compounds, benzylphenyl compounds, compounds having tertiary amines connected to each other through a fluorene group, hydrazone compounds, silazane compounds, silanamine compounds, phosphamine compounds, and quinacridone compounds; and electron-transporting compounds such as anthracene compounds, pyrene compounds, carbazole compounds, pyridine compounds, phenanthroline compounds, oxadiazole compounds, and silole compounds.

Also preferred for use as the charge-transporting material are, for example, the compounds exemplified as the hole-transporting compound of the hole transport layer 4, such as aromatic diamines which contain two or more tertiary amines and in which two or more fused aromatic rings are substituted with nitrogen atoms, as typified by 4,4'-bis[N-(1-naphthyl)-N-phenylamino]biphenyl (Japanese Unexamined Patent Application Publication No. 5-234681); aromatic amine compounds having a starburst structure, such as 4,4',4"-tris(1-naphthylphenylamino)triphenylamine (J. Lumin., vols. 72-74, p. 985, 1997); aromatic amine compounds composed of a tetramer of triphenylamine (Chem. Commun., p. 2175, 1996); fluoren compounds such as 2,2',7,7'-tetrakis-(diphenylamino)-9,9'-spirobifluorene (Synth. Metals, vol. 91, p. 209, 1997); and carbazole compounds such as 4,4'-N,N'-dicarbazolebiphenyl. Examples of the charge-transporting material also include oxadiazole compounds such as 2-(4-biphenylyl)-5-(p-tert-butylphenyl)-1,3,4-oxadiazole (tBu-PBD) and 2,5-bis(1-naphthyl)-1,3,4-oxadiazole (BND); silole compounds such as 2,5-bis(6'-(2',2"-bipyridyl))-1,1-dimethyl-3,4-diphenylsilole (PyPySPyPy); and phenanthroline compounds such as bathophenanthroline (BPhen) and 2,9-dimethyl-4,7-diphenyl-1,10-phenanthroline (BCP, bathocuproine).

### (Formation of light-emitting layer 5 by wet film-forming method)

The light-emitting layer 5 may be formed by a vacuum deposition method or a wet film-forming method. In terms of high film formability, the wet film-forming method is preferred.

When the light-emitting layer 5 is formed by a wet film-forming method, it is typically formed as in the case where the hole injection layer 3 is formed by a wet film-forming method, except that the composition for hole injection layer formation is replaced with a composition for light-emitting layer formation prepared by mixing a material that will form the light-emitting layer 5 with an appropriate solvent (a solvent for a light-emitting layer). In the present invention, the iridium complex compound-containing composition of the present invention is preferably used as the composition for light-emitting layer formation.

Examples of the solvent include the solvents exemplified for the formation of the hole injection layer 3, such as ether solvents, ester solvents, aromatic hydrocarbon solvents, and amide solvents; and alkane solvents, halogenated aromatic hydrocarbon solvents, aliphatic alcohol solvents, alicyclic alcohol solvents, aliphatic ketone solvents, and alicyclic ketone solvents. The solvent used is as exemplified also as the solvent of the iridium complex compound-containing composition of the present invention. Specific examples of the solvent are given below, but other solvents may also be used as long as the effects of the present invention are not impaired.

Examples include aliphatic ether solvents such as ethylene glycol dimethyl ether, ethylene glycol diethyl ether, and propylene glycol-1-monomethyl ether acetate (PGMEA); aromatic ether solvents such as 1,2-dimethoxybenzene, 1,3-dimethoxybenzene, anisole, phenetole, 2-methoxytoluene, 3-methoxytoluene, 4-methoxytoluene, 2,3-dimethylanisole, 2,4-dimethylanisole, and diphenyl ether; aromatic ester solvents such as phenyl acetate, phenyl propionate, methyl benzoate, ethyl benzoate, propyl benzoate, and n-butyl benzoate; aromatic hydrocarbon solvents such as toluene, xylene, mesitylene, cyclohexylbenzene, tetralin, 3-isopropylbiphenyl, 1,2,3,4-tetramethylbenzene, 1,4-diisopropylbenzene, and methylnaphthalene; amide solvents such as N,N-dimethylformamide and N,N-dimethylacetamide; alkane solvents such as n-decane, cyclohexane, ethylcyclohexane, decalin, and bicyclohexane; halogenated aromatic hydrocarbon solvents such as chlorobenzene, dichlorobenzene, and trichlorobenzene; aliphatic alcohol solvents such as butanol and hexanol; alicyclic alcohol solvents such as cyclohexanol and cyclooctanol; aliphatic ketone solvents such as methyl ethyl ketone and dibutyl ketone; and alicyclic ketone solvents such as cyclohexanone, cyclooctanone, and fenchone. Of these, alkane solvents and aromatic hydrocarbon solvents are particularly preferred.

To form a more uniform film, the solvent is preferably evaporated from a freshly formed liquid film at an appropriate rate. Thus, the boiling point of the solvent used, as described above, is typically 80°C or more, preferably 100°C or more, more preferably 120°C or more, and typically 270°C or less, preferably 250°C or less, more preferably 230°C or less.

The solvent may be used in any amount as long as the effects of the present invention are not greatly impaired, but the total content of the solvent in the composition for light-emitting layer formation, that is, the iridium complex compound-containing composition is preferably high in terms of ease of film-forming operation due to a low viscosity, and is preferably low in terms of ease of film formation due to a thick film. As described above, the content of the solvent in the iridium complex compound-containing composition is preferably 1 mass% or more, more preferably 10 mass% or more, particularly preferably 50 mass% or more, and preferably 99.99 mass% or less, more preferably 99.9 mass% or less, particularly preferably 99 mass% or less.

The solvent can be removed after the wet film formation, for example, by heating or pressure reduction. The heating means used for heating is preferably a clean oven or a hot plate because heat is uniformly applied to the whole film.

The heating temperature in the heating process, although not particularly limited as long as the effects of the present invention are not greatly impaired, is preferably high in terms of reduction in drying time, and is preferably low in terms of reduction in damage to the materials. The upper limit of the heating temperature is typically 250°C or less, preferably 200°C or less, more preferably 150°C or less. The lower limit of the heating temperature is typically 30°C or more, preferably 50°C or more, more preferably 80°C or more. Temperatures over the upper limit are higher than the level of heat resistance of a commonly used charge transport material or phosphorescent material and may disadvantageously cause decomposition or crystallization. When the heating temperature is below the lower limit, removal of the solvent disadvantageously requires a long time. The heating temperature in the heating process is appropriately determined according to the boiling point of the solvent in the composition for light-emitting layer formation, the vapor pressure, the heat resistance of the materials, and the heating conditions.

### (Formation of light-emitting layer 5 by vacuum deposition method)

When the light-emitting layer 5 is formed by a vacuum deposition method, it is typically formed as described below. One or more of the constituent materials (e.g., the light-emitting material and the charge transport compound) of the light-emitting layer 5 are placed in a crucible mounted in a vacuum chamber (when two or more materials are used, they are typically placed in different crucibles), and the vacuum chamber is evacuated with a vacuum pump to about 10⁻⁴ Pa. Thereafter, the crucible is heated (when two or more materials are used, the crucibles are typically each heated), and the material in the crucible is evaporated while controlling the amount of evaporation (when two or more materials are used, the materials are typically independently evaporated while controlling the amount of evaporation) to form the light-emitting layer 5 on the hole injection layer 3 or the hole transport layer 4 placed so as to face the crucible. When two or more materials are used, a mixture thereof may be placed in a crucible, and heated and evaporated to form the light-emitting layer 5.

The degree of vacuum during the deposition is not particularly limited as long as the effects of the present invention are not greatly impaired, and is typically 0.1 × 10⁻⁶ Torr (0.13 × 10⁻⁴ Pa) or more and 9.0 × 10⁻⁶ Torr (12.0 × 10⁻⁴ Pa) or less. The rate of deposition is not particularly limited as long as the effects of the present invention are not greatly impaired, and is typically 0.1 Å/s or more and 5.0 Å/s or less. The film formation temperature during the deposition is not particularly limited as long as the effects of the present invention are not greatly impaired, and is preferably 10°C or more and 50°C or less.

### <Hole blocking layer 6>

A hole blocking layer 6 may be disposed between the light-emitting layer 5 and an electron injection layer 8 described later. The hole blocking layer 6 is a layer stacked on the light-emitting layer 5 so as to be in contact with a surface of the light-emitting layer 5 on the cathode 9 side.

The hole blocking layer 6 serves to prevent holes moving from the anode 2 from reaching the cathode 9 and to efficiently transport electrons injected from the cathode 9 toward the light-emitting layer 5. The material forming the hole blocking layer 6 is required to have physical properties such as high electron mobility, low hole mobility, a large energy gap (difference between HOMO and LUMO), and a high excited triplet level (T1).

Examples of materials of the hole blocking layer 6 that satisfy such requirements include mixed ligand complexes such as bis(2-methyl-8-quinolinolate)(phenolate)aluminum and bis(2-methyl-8-quinolinolate) (triphenylsilanolate) aluminum; metal complexes such as a bis(2-methyl-8-quinolate)aluminum-µ-oxo-bis-(2-methyl-8-quinolinolate)aluminum dinuclear metal complex; styryl compounds such as distyrylbiphenyl derivatives (Japanese Unexamined Patent Application Publication No. 11-242996); triazole derivatives such as 3-(4-biphenylyl)-4-phenyl-5(4-tert-butylphenyl)-1,2,4-triazole (Japanese Unexamined Patent Application Publication No. 7-41759); and phenanthroline derivatives such as bathocuproine (Japanese Unexamined Patent Application Publication No. 10-79297). A compound having at least one pyridine ring substituted at the 2-, 4-, and 6- positions described in International Publication No. 2005/022962 is also preferred as the material of the hole blocking layer 6.

The hole blocking layer 6 may be formed by any method, and can be formed in the same manner as the light-emitting layer 5.

The thickness of the hole blocking layer 6, although not particularly limited as long as the effects of the present invention are not greatly impaired, is typically 0.3 nm or more, preferably 0.5 nm or more, and typically 100 nm or less, preferably 50 nm or less.

### <Electron transport layer 7>

An electron transport layer 7 is disposed between the light-emitting layer 5 or the hole blocking layer 6 and the electron injection layer 8 for the purpose of further improving the current efficiency of the element.

The electron transport layer 7 is formed of a compound that, between the electrodes under an electric field, is capable of efficiently transporting electrons injected from the cathode 9 toward the light-emitting layer 5. The electron-transporting compound used for the electron transport layer 7 needs to be a compound into which electrons from the cathode 9 or the electron injection layer 8 are injected with high efficiency and which has high electron mobility so that injected electrons can be efficiently transported.

Examples of electron-transporting compounds that satisfy such requirements include metal complexes such as aluminum complexes of 8-hydroxyquinoline (Japanese Unexamined Patent Application Publication No. 59-194393), metal complexes of 10-hydroxybenzo[h]quinoline, oxadiazole derivatives, distyrylbiphenyl derivatives, silole derivatives, 3-hydroxyflavone metal complexes, 5-hydroxyflavone metal complexes, benzoxazole metal complexes, benzothiazole metal complexes, trisbenzimidazolylbenzene (U.S. Patent No. 5645948), quinoxaline compounds (Japanese Unexamined Patent Application Publication No. 6-207169), phenanthroline derivatives (Japanese Unexamined Patent Application Publication No. 5-331459), 2-t-butyl-9,10-N,N'-dicyanoanthraquinonediimine, n-type hydrogenated amorphous silicon carbide, n-type zinc sulfide, and n-type zinc selenide.

The thickness of the electron transport layer 7 is typically 1 nm or more, preferably 5 nm or more, and typically 300 nm or less, preferably 100 nm or less.

The electron transport layer 7 is formed by being stacked on the light-emitting layer 5 or the hole blocking layer 6 by a wet film-forming method or a vacuum deposition method as with the light-emitting layer 5. Typically, a vacuum deposition method is used.

### <Electron injection layer 8>

The electron injection layer 8 serves to efficiently inject electrons injected from the cathode 9 into the electron transport layer 7 or the light-emitting layer 5.

To achieve efficient electron injection, the material forming the electron injection layer 8 is preferably a metal with a low work function. Examples include alkali metals such as sodium and cesium and alkaline-earth metals such as barium and calcium.

The thickness of the electron injection layer 8 is preferably 0.1 to 5 nm.

To interpose, as the electron injection layer 8, an ultrathin insulating film (about 0.1 to 5 nm thick) of LiF, MgF₂, Li₂O, Cs₂CO₃, or the like between the cathode 9 and the electron transport layer 7 is also an effective means for improving the efficiency of the element (Appl. Phys. Lett., vol. 70, p. 152, 1997; Japanese Unexamined Patent Application Publication No. 10-74586; IEEE Trans. Electron. Devices, vol. 44, p. 1245, 1997; and SID 04 Digest, p. 154).

Furthermore, to dope an organic electron transport material, as typified by nitrogen-containing heterocyclic compounds such as bathophenanthroline and metal complexes such as aluminum complexes of 8-hydroxyquinoline, with an alkali metal such as sodium, potassium, cesium, lithium, or rubidium (described in Japanese Unexamined Patent Application Publication No. 10-270171, Japanese Unexamined Patent Application Publication No. 2002-100478, Japanese Unexamined Patent Application Publication No. 2002-100482, etc.) is preferred because the electron injection/transport ability can be improved to achieve excellent film quality. In this case, the thickness of the film is typically 5 nm or more, preferably 10 nm or more, and typically 200 nm or less, preferably 100 nm or less.

The electron injection layer 8 is formed by being stacked on the light-emitting layer 5 or on the hole blocking layer 6 or the electron transport layer 7 thereon by a wet film-forming method or a vacuum deposition method as with the light-emitting layer 5.

Details in the case of a wet film-forming method are the same as in the case of the light-emitting layer 5.

### <Cathode 9>

The cathode 9 serves to inject electrons into a layer on the light-emitting layer 5 side (e.g., the electron injection layer 8 or the light-emitting layer 5). The material of the cathode 9 may be the same as the material used for the anode 2. For efficient electron injection, it is preferable to use a metal with a low work function, such as tin, magnesium, indium, calcium, aluminum, silver, or an alloy thereof. Examples of the material of the cathode 9 include alloy electrodes with a low work function, such as magnesium-silver alloys, magnesium-indium alloys, and aluminum-lithium alloys.

In terms of element stability, a metal layer having a high work function and stable to the atmosphere is preferably stacked on the cathode 9 to protect the cathode 9 formed of a metal with a low work function. Examples of the metal stacked include metals such as aluminum, silver, copper, nickel, chromium, gold, and platinum.

The thickness of the cathode is typically the same as that of the anode 2.

### <Other constituent layers>

While the description has been made mainly in the context of an element with a layer structure illustrated in Fig. 1, any desired layers, in addition to the layers described above, may be disposed between the anode 2 and the light-emitting layer 5 and between the cathode 9 and the light-emitting layer 5 in the organic electroluminescent element of the present invention, or any of the layers other than the light-emitting layer 5 may be omitted, as long as the performance of the element is not impaired.

For example, to dispose an electron blocking layer between the hole transport layer 4 and the light-emitting layer 5 is also effective for the same purpose as that of the hole blocking layer 6. The electron blocking layer serves to prevent electrons moving from the light-emitting layer 5 from reaching the hole transport layer 4, thereby increasing the probability of recombination of electrons with holes in the light-emitting layer 5 and confining the resultant excitons in the light-emitting layer 5, and also serves to efficiently transport holes injected from the hole transport layer 4 toward the light-emitting layer 5.

The electron blocking layer is required to have properties such as high hole transport ability, a large energy gap (difference between HOMO and LUMO), and a high excited triplet level (T1).

When the light-emitting layer 5 is formed by a wet film-forming method, the electron blocking layer is also preferably formed by a wet film-forming method for ease of element production.

Thus, the electron blocking layer also preferably has suitability for wet film formation, and examples of materials used for such electron blocking layers include copolymers of dioctylfluorene and triphenylamine, as typified by F8-TFB (International Publication No. 2004/084260).

The structure in Fig. 1 may be reversed; specifically, the cathode 9, the electron injection layer 8, the electron transport layer 7, the hole blocking layer 6, the light-emitting layer 5, the hole transport layer 4, the hole injection layer 3, and the anode 2 may be stacked in this order on the substrate 1. It is also possible to dispose the organic electroluminescent element of the present invention between two substrates at least one of which is highly transparent.

A structure formed of a plurality of the layer structures illustrated in Fig. 1 stacked on top of each other (a structure formed of a plurality of light-emitting units stacked on top of each other) is also possible. In this case, from the viewpoint of light emission efficiency and drive voltage, it is more preferable to use, for example, V₂O₅ as a charge generation layer in place of the interfacial layer (when the anode is ITO and the cathode is Al, the interfacial layer means these two layers) between the stages (between the light-emitting units) because such a configuration reduces the barrier between the stages.

The present invention can be applied to any of a single organic electroluminescent element, organic electroluminescent elements configured in an array arrangement, and a structure in which anodes and cathodes are arranged in an X-Y matrix.

### [Display device and illumination device]

A display device and an illumination device of the present invention each include the organic electroluminescent element of the present invention as described above. The display device and the illumination device of the present invention may be of any type and may have any structure, and can be assembled according to an ordinary method by using the organic electroluminescent element of the present invention.

For example, the display device and the illumination device of the present invention can be formed by a method as described in "Organic EL Display" (Ohmsha, Ltd., published August 20, 2004, written by Shizuo Tokito, Chihaya Adachi, and Hideyuki Murata).

### EXAMPLES

The present invention will now be described in more detail with reference to examples. The present invention is not limited to the following examples, and any modifications can be made without departing from the scope of the present invention.

In the following Synthesis Examples, all reactions were performed under a stream of nitrogen.

### [Synthesis of iridium complex compound]

### <Synthesis Example 1: Synthesis of compound 1>

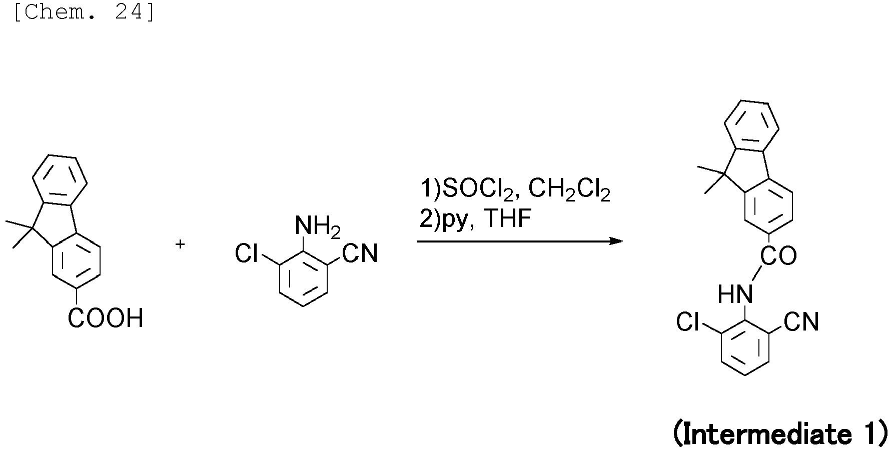

In a 200 mL flask, 9,9-dimethylfluorene-2-carboxylic acid (5.0 g), dry dichloromethane (100 mL), thionyl chloride (3.3 g), and N,N-dimethylformamide (100 µL) were placed in this order and stirred at room temperature for 1.5 hours. The solvent was removed under reduced pressure, and dry tetrahydrofuran (5 mL) was added to the residue.
Furthermore, a solution of 2-amino-3-chlorobenzonitrile (2.7 g) in dry pyridine (10 mL) was added thereto, and the resulting mixture was stirred at room temperature. After 10 minutes, 2-amino-3-chlorobenzonitrile (0.7 g) was further added thereto, and the resulting mixture was stirred at room temperature for 3 hours in total. The solvent was removed under reduced pressure, and the residue was washed with toluene (300 mL) and 1 N hydrochloric acid (130 mL) by separation. After drying over magnesium sulfate, the resultant was filtered and dried under reduced pressure to obtain 8.8 g of intermediate 1 as a yellow solid. Intermediate 1 was subjected to the next reaction without purification.

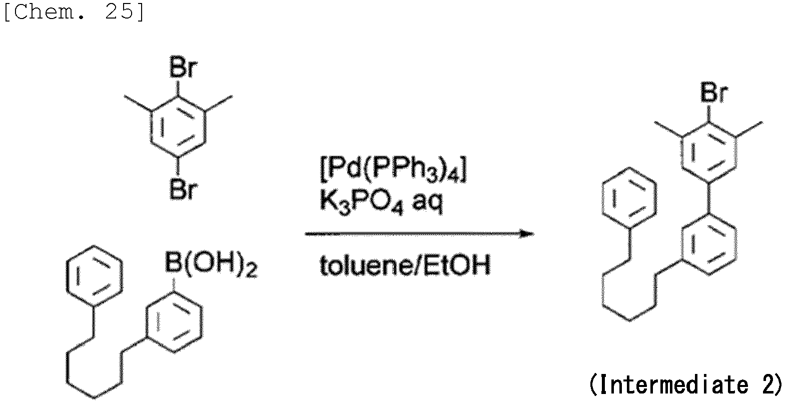

In a 1 L recovery flask, 2,6-dibromo-m-xylene (27.5 g), 3-(6-phenyl-n-hexyl)phenylboronic acid (30.3 g), tetrakis(triphenylphosphine)palladium(0) (2.5 g), a 2M aqueous tripotassium phosphate solution (2,500 mL), toluene (300 mL), and ethanol (100 mL) were placed, and stirring at reflux was performed for 3 hours in an oil bath at 100°C.

The resulting mixture was then cooled to room temperature. The aqueous phase was removed, and the solvent was removed under reduced pressure. The residue was purified by silica gel column chromatography (neutral gel: 650 mL, hexane alone) to obtain 39.4 g of intermediate 2 as a colorless oily substance.

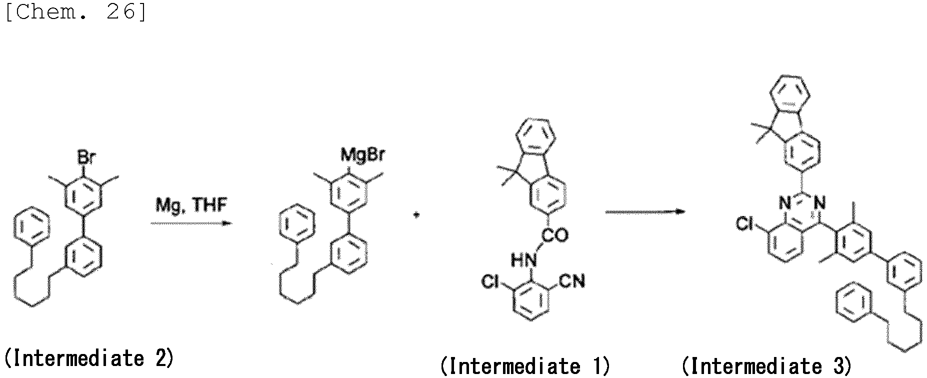

Magnesium turnings (2.2 g) were placed in a 200 mL flask and stirred for 1 hour under reduced pressure. Thereafter, a solution of intermediate 2 (37.8 g) in dry tetrahydrofuran (45 mL) was added dropwise thereto over 30 minutes at room temperature. Thereafter, the resulting mixture was further stirred at room temperature for 1 hour. The reaction solution was added dropwise to a solution of intermediate 1 (8.8 g) in dry tetrahydrofuran (35 mL) at room temperature, and the resulting mixture was stirred at 85°C for 3 hours. Thereafter, an aqueous saturated ammonium chloride solution (10 mL) was added thereto, and the solvent was then removed under reduced pressure. The residue was purified by silica gel column chromatography (acidic gel: 500 mL, hexane → hexane/ethyl acetate = 8/2) to obtain 11.1 g (net) of intermediate 3 (Debrominated and dehydrogenated intermediate 2 was contained, and the gross weight was 13.3 g. Since there was no influence on the next reaction, the mixture was subjected to the next reaction without purification).

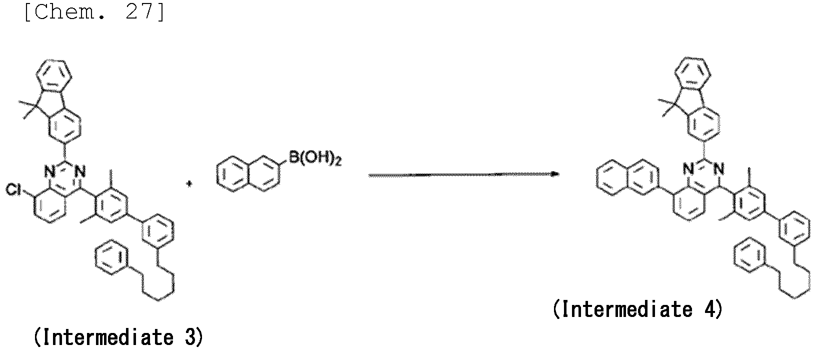

In a 1 L recovery flask, intermediate 3 (11.1 g, net), 2-naphthaleneboronic acid (5.4 g), palladium acetate (183 mg), S-Phos (2-dicyclohexylphosphino-2',6'-dimethoxybiphenyl) (656 mg), tripotassium phosphate (6.6 g), and dehydrated and deoxygenated toluene (100 mL) were placed, and stirring was performed in an oil bath at 130°C. During the stirring, sodium hydroxide (2.0 g), ethanol (25 mL), and water (25 mL) were added after 3 hours; potassium hydroxide (2.7 g), palladium acetate (100 mg), S-Phos (400 mg), and tetrahydrofuran (10 mL) were added after 4 hours; barium hydroxide octahydrate (3.0 g), palladium acetate (100 mg), S-Phos (400 mg), and tetrahydrofuran (10 mL) were added after 5 hours; 2-naphthaleneboronic acid (2.3 g), palladium acetate (100 mg), S-Phos (400 mg), and tetrahydrofuran (10 mL) were added after 6 hours; and potassium hydroxide (1.2 g), ethanol (50 mL), and water (50 mL) were added after 6.5 hours. The reaction was performed for a total of 11 hours, but the rate of inversion was low.

On the following day, tetrakis triphenylphosphine palladium(0) (1.2 g) was added to the reaction product, and stirring was resumed at 120°C. N,N-Dimethylformamide (100 mL) was added after 1 hour; 2-naphthaleneboronic acid (3.1 g), palladium acetate (100 mg), S-Phos (400 mg), and N,N-dimethylformamide (15 mL) were added after 2.5 hours; and palladium acetate (100 mg), S-Phos (400 mg), and N,N-dimethylformamide (15 mL) were added after 3.5 hours. The reaction was performed for a total of 8 hours, and the raw materials were consumed. The solvent was then removed under reduced pressure, and the resulting residue was purified by silica gel column chromatography (neutral gel: 700 mL, dichloromethane/hexane = 2/8 to 1/1) to obtain 11.0 g of intermediate 4 as an orange solid.

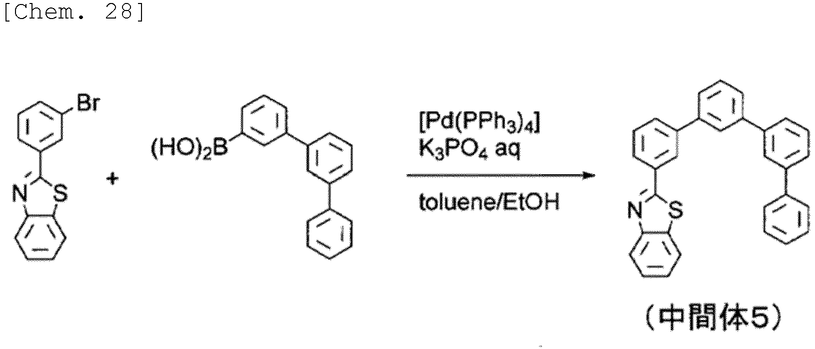

In a 1 L recovery flask, 2-(3-bromophenyl)benzothiazole (31.7 g), B-[1,1':3',1"-terphenyl]-3-ylboronic acid (33.7 g), and tetrakis(triphenylphosphine)palladium(0) (2.2 g) were placed. Nitrogen-bubbled toluene (350 mL), ethanol (100 mL), and a 2M aqueous tripotassium phosphate solution (200 mL) were further added thereto, and the resulting mixture was stirred at 100°C for 4 hours. After cooling to room temperature, the aqueous phase was removed, and the solvent was removed. The resulting residue was purified by silica gel column chromatography (gel: 600 mL, dichloromethane/hexane = 3/7 → 5/5) to obtain 45.9 g of intermediate 5.

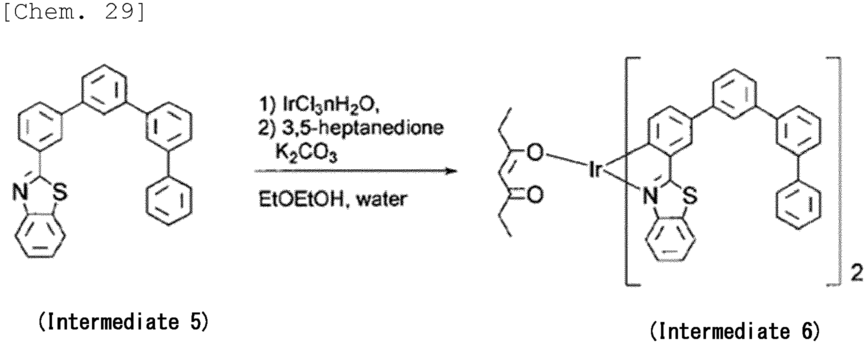

In a 1 L recovery flask, intermediate 5 (28.9 g), iridium chloride n-hydrate (manufactured by Furuya Metal Co., Ltd., iridium content: 52%) (10.7 g), 2-ethoxyethanol (0.7 L), and water (60 mL) were placed and stirred at reflux for 9 hours. The precipitate was filtered to obtain a cake, and a half amount of the cake was placed in a 500 mL recovery flask. 3,5-Heptanedione (7.4 g), potassium carbonate (10.2 g), and 2-ethoxyethanol (250 mL) were added thereto, and the resulting mixture was stirred at reflux for 8 hours. After cooling to room temperature, the solvent in the liquid obtained by filtration was removed under reduced pressure, and the resulting residue was purified by silica gel column chromatography (gel: 500 mL, eluent: dichloromethane) to obtain 14.9 g of intermediate 6.

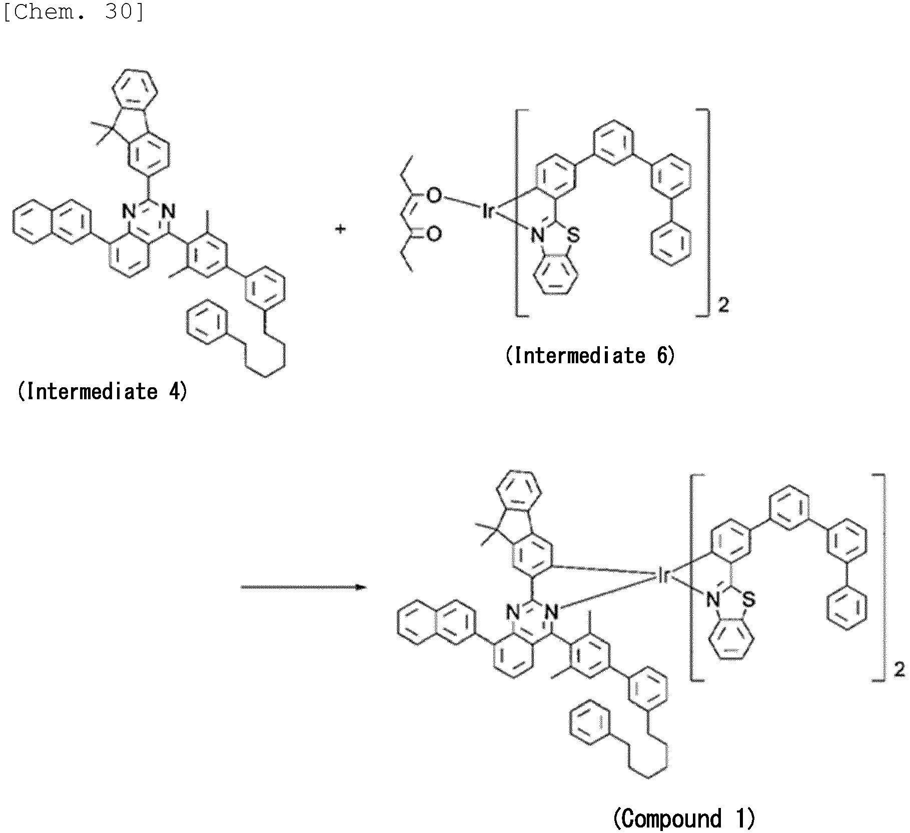

In a 100 mL recovery flask, intermediate 4 (10.8 g), intermediate 6 (4.2 g), silver trifluoromethanesulfonate (1.5 g), and toluene (7.5 mL) were placed, and stirring was performed in an oil bath at 225°C for 2 hours. During the reaction, volatilizing toluene was removed by flowing nitrogen through a three-way cock directly connected to the 100 mL recovery flask. After cooling to room temperature, the resulting solid was purified by silica gel column chromatography (neutral gel: 400 mL, after elution with toluene/hexane = 35/65 to 1/1, the target was eluted down with dichloromethane/hexane = 1/1) to obtain 0.96 g of compound 1 as a red solid.

### <Synthesis Example 2: Synthesis of compound 2>

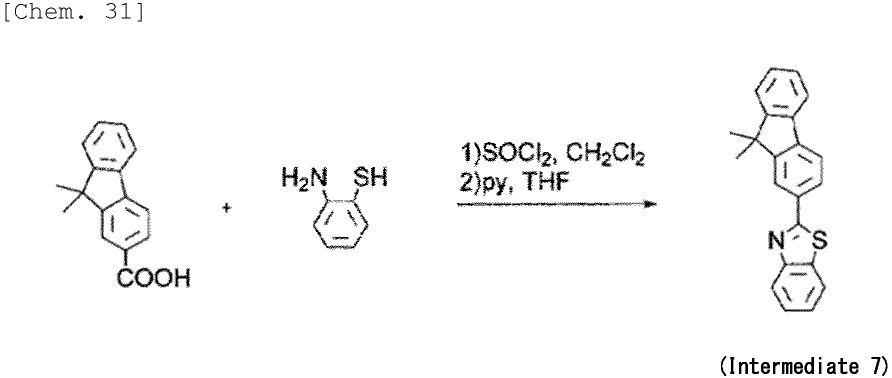

In a 1 L recovery flask, 9,9-dimethylfluorene-2-carboxylic acid (4.9 g), dry dichloromethane (100 mL), thionyl chloride (2 mL), and N,N-dimethylformamide (100 µL) were placed in this order and stirred at room temperature for 2 hours. The solvent was removed under reduced pressure, and dry N-methylpyrrolidone (50 mL) was added to the residue. Furthermore, a solution of 2-aminothiophenol (2.6 g) in dry N-methylpyrrolidone (50 mL) was added thereto, and the resulting mixture was stirred at room temperature for 2 hours. The reaction solution was put in water (800 mL), neutralized with a 2M aqueous tripotassium phosphate solution (100 mL), and then filtered. The resultant was washed with water and then dried under reduced pressure to obtain 6.2 g of intermediate 7 as a cream colored solid.

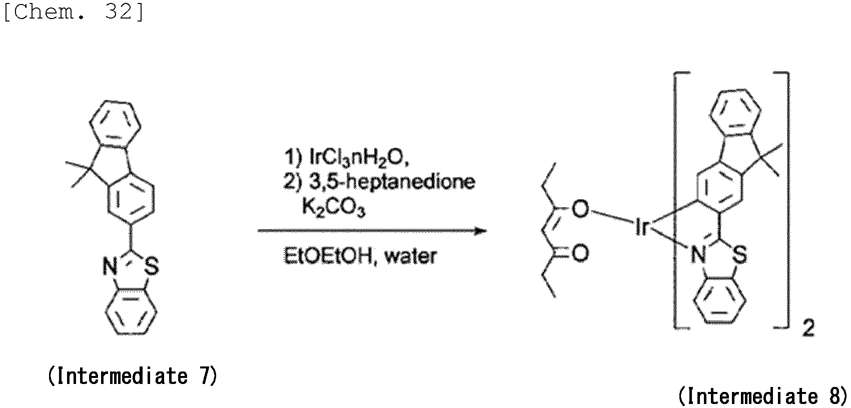

In a 1 L recovery flask, intermediate 7 (6.2 g), iridium chloride n-hydrate (manufactured by Furuya Metal Co., Ltd., iridium content: 52%) (3.2 g), 2-ethoxyethanol (50 mL), and water (10 mL) were placed and stirred at reflux for 6 hours. The precipitate was filtered to obtain a cake (9.1 g), and 5.0 g of the cake was placed in a 1 L recovery flask. 3,5-Heptanedione (2.6 g), potassium carbonate (8.0 g), and 2-ethoxyethanol (200 mL) were added thereto, and the resulting mixture was stirred at reflux for 1 hour and 45 minutes. After cooling to room temperature, the solvent was removed under reduced pressure, and the resulting residue was washed with dichloromethane (300 mL) and water (300 mL) by separation. Thereafter, the solvent in the oil phase was removed, and the resulting residue was purified by silica gel column chromatography (gel: 500 mL, eluent: dichloromethane/hexane = 8/2) to obtain 2.0 g of intermediate 8. 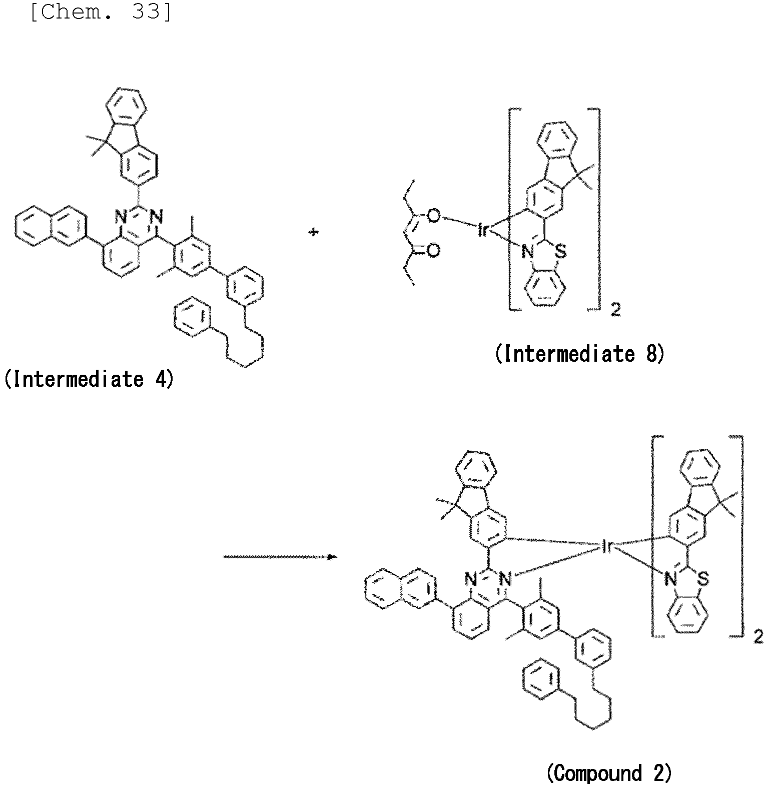 In a 100 mL recovery flask, intermediate 8 (1.4 g), intermediate 4 (4.3 g), and silver trifluoromethanesulfonate (0.57 g) were placed, and stirring was performed for 2 hours in an oil bath at 220°C. After cooling to room temperature, the resulting solid was purified by silica gel column chromatography (neutral gel: 400 mL, after elution with toluene/hexane = 4/6 to 1/1, the target was eluted down with dichloromethane/hexane = 1/1) to obtain 0.8 g of compound 2 as a red solid.

### [Comparison of solvent solubility]

### <Example 1>

Compound 1 was mixed with cyclohexylbenzene at a concentration of 3 mass%. At room temperature for 2 minutes, solubility was observed only by means of manual shaking. Thereafter, the solution was heated on a hot plate at 100°C for 5 minutes and then allowed to sit at room temperature for 40 hours. The occurrence of precipitation was observed at each timing.

### <Example 2 and Comparative Examples 1 and 2>

The same procedure as in Example 1 was performed except that compound 1 was replaced with compound 2, compound D-1 below, or compound D-2 below. Compound D-1 was synthesized on the basis of the description of International Publication No. 2015/087961, and compound D-2 was synthesized on the basis of the description of International Publication No. 2014/024889.

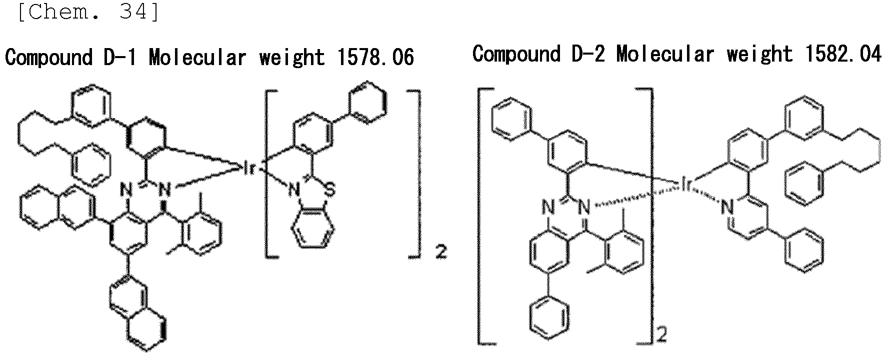

The results are summarized in Table 1.

Table 1 shows that the iridium complex compounds of the present invention are excellent in solubility at the time of dissolution and also in dissolution stability at hours after the dissolution.

**[Table 1]**

| | Iridium complex compound | When shaken by hand at room temperature for 2 minutes | When heated at 100°C for 5 minutes | After 40 hours at room temperature |
|---|---|---|---|---|
| Example 1 | Compound 1 | Rapidly dissolved | Dissolved into homogeneous solution | Remained homogeneous |
| Example 2 | Compound 2 | Rapidly dissolved | Dissolved into homogeneous solution | Remained homogeneous |
| Comparative Example 1 | Compound D-1 | Large amount remained undissolved | Dissolved into homogeneous solution | Large amount precipitated |
| Comparative Example 2 | Compound D-2 | Small amount remained undissolved | Dissolved into homogeneous solution | Remained homogeneous |

### [Measurement of maximum emission wavelength and half-width]

### <Example 3>

Compound 1 was dissolved in 2-methyltetrahydrofuran (manufactured by Aldrich, dehydrated, no stabilizer added) at normal temperature to prepare a solution with a concentration of 1 × 10⁻⁵ mol/L. The solution was placed in a quartz cell equipped with a Teflon (registered trademark) cock, and after nitrogen bubbling was performed for 20 minutes or more, a phosphorescence spectrum was measured at room temperature. The wavelength at a maximum intensity in the measured phosphorescence spectrum was used a maximum emission wavelength. The width at a spectrum intensity at half the maximum emission wavelength was used as a half-width.

For the measurement of the emission spectrum, the following instruments were used.

Apparatus: C9920-02 organic EL quantum yield spectrometer manufactured by Hamamatsu Photonics K.K.

Light source: L9799-01 monochromatic light source
Detector: PMA-11 multichannel detector
Excitation light: 380 nm

### <Example 4 and Comparative Examples 3 and 4>

The same procedure as in Example 3 was performed except that compound 1 was replaced with compound 2, compound D-1 above, or compound D-2 above.

The results are shown in Table 2 and Fig. 2.

In Fig. 2, Example 3 and Example 4 each had a half-width larger than half-widths at maximum emission wavelengths of Example 3 and Example 4 represented by a line passing through data of Comparative Example 3 and Comparative Example 4. These results show that the iridium complex compounds of the present invention each have a large half-width deviated from the linear relationship between maximum emission wavelength and half-width of Comparative Example 3 and Comparative Example 4.

**[Table 2]**

| | Iridium complex compound | Maximum emission wavelength (nm) | Half-width (nm) |
|---|---|---|---|
| Example 3 | Compound 1 | 610 | 95 |
| Example 4 | Compound 2 | 619 | 104 |
| Comparative Example 3 | Compound D-1 | 618 | 99 |
| Comparative Example 4 | Compound D-2 | 616 | 97 |

### [Synthesis of iridium complex compound]

### <Synthesis Example 3: Synthesis of compound 3>

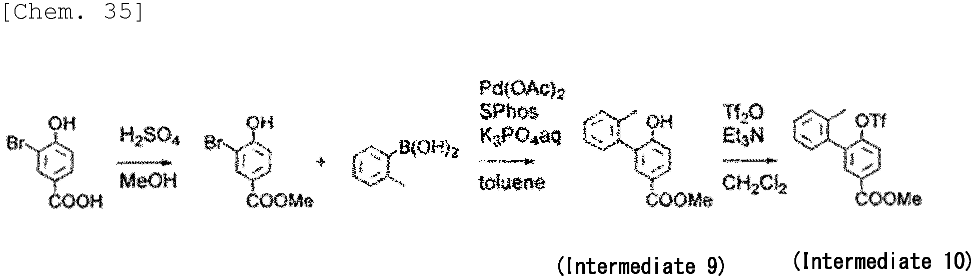

### (Reaction 1)

In a 1 L recovery flask, 3-bromo-4-hydroxybenzoic acid (50 g), methanol (400 mL), and sulfuric acid (23 mL) were placed, and stirring at reflux was performed for 3 hours in an oil bath at 95°C. Thereafter, sodium carbonate (60 g) and water (200 mL) were added thereto to be basic, and the resulting mixture was then extracted six times with dichloromethane (250 mL). To the aqueous phase, 35% hydrochloric acid (15 mL) was added, and the resulting mixture was extracted five times with dichloromethane (250 mL). The oil phase was dried over magnesium sulfate (50 mL) and filtered, and the solvent was then removed under reduced pressure to obtain 53.6 g of a methyl ester.

### (Reaction 2)

To the methyl ester (27.7 g) of reaction 1, 2-methylphenylboronic acid (16.5 g), palladium acetate (0.50 g), S-Phos (2-dicyclohexylphosphino-2',6-dimethoxybiphenyl) (1.9 g), tripotassium phosphate (46.3 g), and deoxygenated toluene (500 mL) were added, and the resulting mixture was stirred at 100°C for 5 hours. Thereafter, 35% hydrochloric acid (40 mL), water (160 mL), and dichloromethane (100 mL) were added thereto, and the oil phase was recovered and dissolved in hot ethanol (100 mL), after which water (250 mL) was added thereto to obtain powder.

This was purified by silica gel column chromatography (neutral gel: 200 mL, dichloromethane/hexane = 3/7 to 1/0) to obtain 23.1 g of intermediate 9.

### (Reaction 3)

In a 1 L recovery flask, intermediate 9 (23.1 g), dichloromethane (350 mL), trifluoromethanesulfonic acid anhydride (35 mL), and triethylamine (30 mL) were placed and stirred at room temperature for 1 hour. Thereafter, water (200 mL) and sodium carbonate (30 g) were added thereto for neutralization, after which the oil phase was dried over magnesium sulfate and filtered, and the solvent was then removed under reduced pressure.

The resulting residue was purified by silica gel column chromatography (eluted with dichloromethane/hexane = 1/1, with 1 cm neutral gel put on a cone having a diameter of 9 cm) to obtain 38.3 g of intermediate 10.

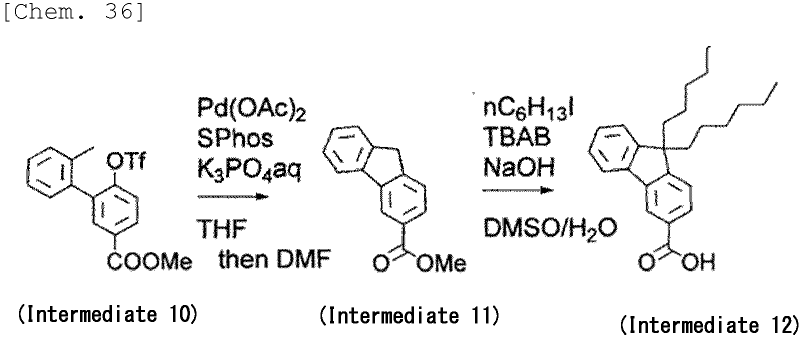

### (Reaction 4)

In a 1 L recovery flask, intermediate 10 (15.5 g), palladium acetate (0.94 g), S-Phos (3.6 g), tripotassium phosphate (17.9 g), and dehydrated tetrahydrofuran (300 mL) were placed, and stirring was performed for 5 hours in an oil bath at 100°C. The reaction solution was cooled and then filtered. The solvent was removed under reduced pressure, and the resulting residue was purified by silica gel column chromatography (neutral gel: 500 mL, dichloromethane/hexane = 2/8 to 3/7) to obtain 6.7 g of intermediate 11.

### (Reaction 5)

In a 1 L recovery flask, intermediate 3 (6.7 g), n-hexyl iodide (15.6 g), tetrabutylammonium bromide (1.9 g), and dimethylsulfoxide (40 mL) were placed. A solution of sodium hydroxide (7.0 g) in water (10 mL) was added dropwise thereto, and the resulting mixture was stirred at room temperature for 2.5 hours. Subsequently, a solution of sodium hydroxide (2.0 g) in water (15 mL) was added dropwise thereto, and the resulting mixture was further stirred for 1.5 hours. Thereafter, an aqueous solution of 35% hydrochloric acid (50 mL) and water (150 mL) was added thereto, and the resulting mixture was extracted with ethyl acetate (200 mL), dried over magnesium sulfate, and filtered. The residue was then purified by silica gel column chromatography (neutral gel: 200 mL, ethyl acetate/hexane = 1/9 to 3/7) to obtain 9.9 g of intermediate 12.

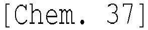

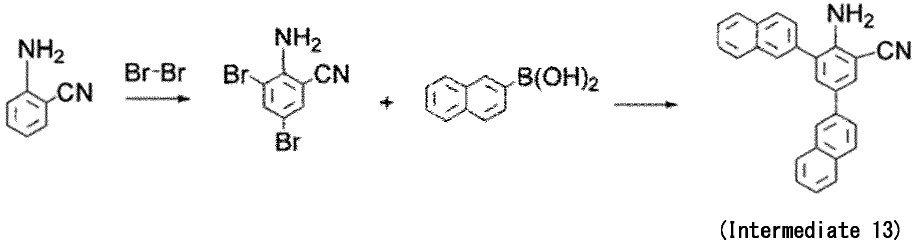

### (Reaction 6)

In a 1 L separable flask, 2-aminobenzonitrile (23.4 g) and acetic acid (500 mL) were placed, and at room temperature, bromine (30 mL) was added dropwise thereto over 20 minutes. In another 1 L separable flask, 2-aminobenzonitrile (50.4 g) and acetic acid (1 L) were placed, and bromine (65 mL) was added dropwise thereto over 20 minutes. After the reactions were performed at room temperature for 5 hours, the reaction products were each mixed with water (50 mL) and filtered.

The residues were combined, washed with water (500 mL) by suspension, and dried under reduced pressure while being heated to obtain 2-amino-3,5-dibromobenzonitrile (141.8 g).

### (Reaction 7)

In a 1 L recovery flask, 2-amino-3,5-dibromobenzonitrile (28.9 g), 2-naphthaleneboronic acid (37.7 g), tetrakis(triphenylphosphine)palladium (5.2 g), 2M tripotassium phosphate (300 mL), toluene (300 mL), and ethanol (100 mL) were placed, and stirring was performed for 4.5 hours in an oil bath at 105°C. During the stirring, 2-naphthylboronic acid (12.5 g) was additionally added. Thereafter, the aqueous phase was removed at room temperature, and the solvent was removed under reduced pressure. The resulting residue was purified by silica gel column chromatography (neutral gel: 650 mL, dichloromethane/hexane = 65/35 to 6/4) to obtain 37.1 g of intermediate 13.

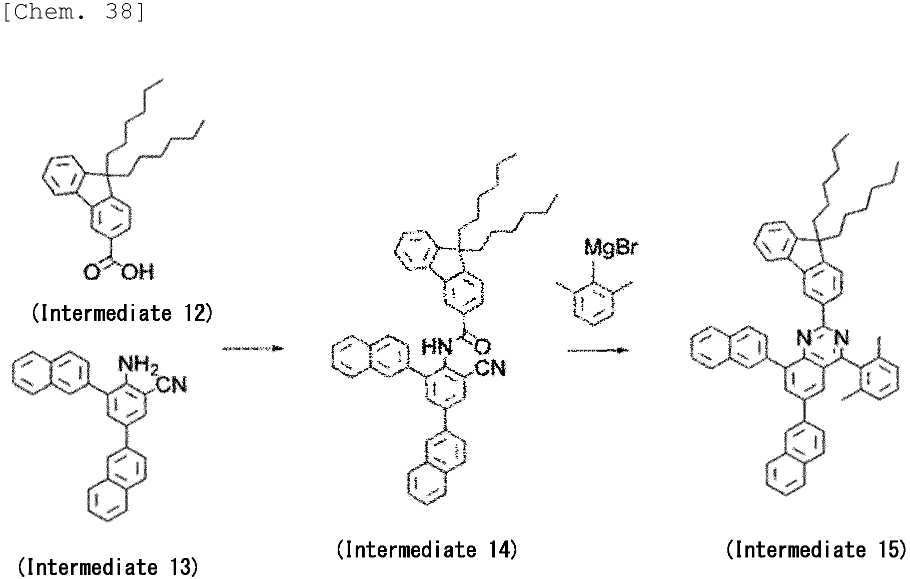

### (Reaction 8)

In a 1 L recovery flask, intermediate 12 (9.9 g), dry dichloromethane (100 mL), thionyl chloride (2.4 mL), and N,N-dimethylformamide (100 µL) were placed and stirred at room temperature for 1.5 hours. Thereafter, the solvent was removed to obtain an acid chloride.

In another 1 L recovery flask, intermediate 13 (10.2 g) and dehydrated pyridine (40 mL) were placed. A solution of the above-prepared acid chloride in tetrahydrofuran (8 mL) was added dropwise thereto, and the resulting mixture was stirred at room temperature for 4 hours. Thereafter, dichloromethane (200 mL) was added thereto, and the resulting mixture was washed with 1 N hydrochloric acid (120 mL) three times. The oil phase was dried over magnesium sulfate and then filtered, and the solvent was removed under reduced pressure to obtain 20.1 g of intermediate 14.

### (Reaction 9)

Magnesium turnings (5.0 g) was placed in a 100 mL flask and stirred for 1 hour under reduced pressure. Thereafter, a solution of 35.0 g of 2-bromo-m-xylene in dry tetrahydrofuran (50 mL) was added dropwise thereto over 30 minutes at room temperature. The resulting mixture was then stirred at room temperature for another 1 hour. The reaction solution was added dropwise to a solution of intermediate 14 (18.9 g) in dry tetrahydrofuran (100 mL) at room temperature, and the resulting mixture was stirred at 85°C for 2 hours. Subsequently, an aqueous saturated ammonium chloride solution (100 mL) was added thereto, and the resulting mixture was extracted with dichloromethane (200 mL). The solvent in the organic phase was removed under reduced pressure, and the residue was purified by silica gel column chromatography (acidic gel: 500 mL, hexane/dichloromethane = 6/4) and reverse phase silica gel column chromatography to obtain 11.5 g of intermediate 15.

### (Reaction 10)

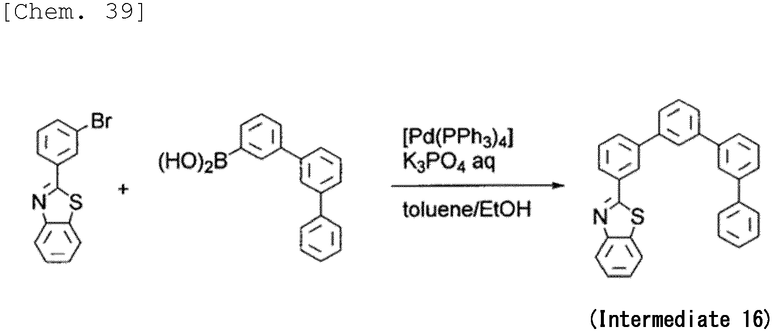

In a 1 L recovery flask, 2-(3-bromophenyl)benzothiazole (31.7 g), B-[1,1':3',1"-terphenyl]-3-ylboronic acid (33.7 g), and tetrakis(triphenylphosphine)palladium(0) (2.2 g) were placed, and nitrogen-bubbled toluene (350 mL), ethanol (100 mL), and a 2M aqueous tripotassium phosphate solution (200 mL) were further added thereto. The resulting mixture was stirred at 100°C for 4 hours. After cooling to room temperature, the aqueous phase was removed, and the solvent was removed. The resulting residue was purified by silica gel column chromatography (gel: 600 mL, dichloromethane/hexane = 3/7 → 5/5) to obtain 45.9 g of intermediate 16.

### (Reaction 11)

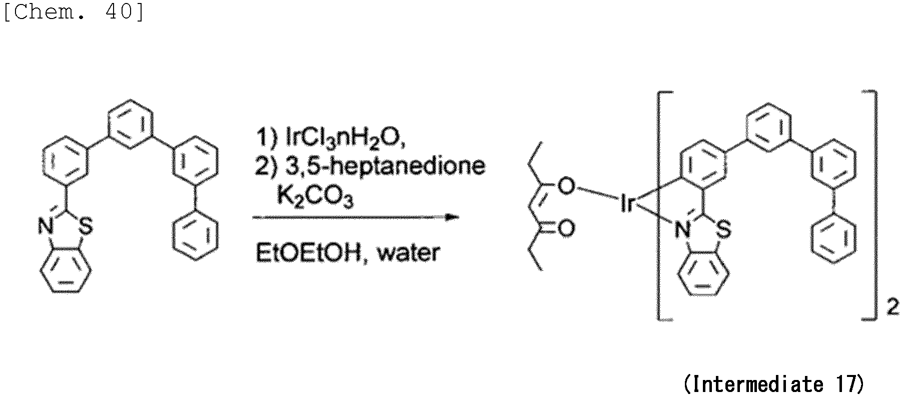

In a 1 L recovery flask, intermediate 16 (28.9 g), iridium chloride n-hydrate (manufactured by Furuya Metal Co., Ltd., iridium content: 52%) (10.7 g), 2-ethoxyethanol (0.7 L), and water (60 mL) were placed and stirred at reflux for 9 hours. The precipitate was filtered to obtain a cake, and a half amount of the cake was placed in a 500 mL recovery flask. 3,5-Heptanedione (7.4 g), potassium carbonate (10.2 g), and 2-ethoxyethanol (250 mL) were added thereto, and the resulting mixture was stirred at reflux for 8 hours. After cooling to room temperature, the solvent in the liquid obtained by filtration was removed under reduced pressure, and the resulting residue was purified by silica gel column chromatography (gel: 500 mL, eluent: dichloromethane) to obtain 14.9 g of intermediate 17.

### (Reaction 12)

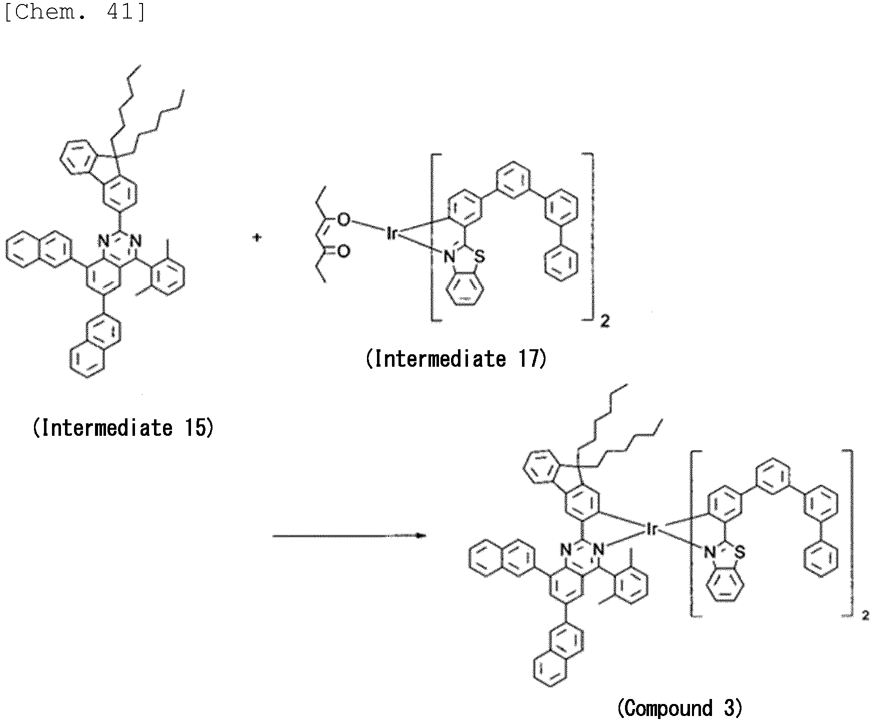

In a 100 mL recovery flask, intermediate 15 (11.5 g) and intermediate 17 (4.2 g) were placed. The flask was placed in an oil bath, and the temperature was raised from room temperature to 220°C. When the temperature in the bath exceeded 210°C, silver trifluoromethanesulfonate (1.5 g) was placed in the flask, and stirring was performed for 3 hours from this point. After 2 hours since the start of the stirring, intermediate 17 (1.0 g) was added. After the reaction, the resulting solid was purified by silica gel column chromatography (neutral gel: 600 mL, dichloromethane/hexane = 3/7) to obtain 0.8 g of compound 3.

### [Evaluation of solvent solubility and dissolution stability after dissolution]

Compound 3 was mixed with cyclohexylbenzene at a concentration of 3 mass%. At room temperature, solubility was observed only by means of manual shaking; all the mixtures were rapidly dissolved. Thereafter, the solutions were heated on a hot plate at 100°C for five minutes and allowed to sit at room temperature for 50 hours. The occurrence of precipitation was observed; all the solutions maintained homogeneity.

### [Example 5]

Compound 3, that is, the iridium complex compound of the present invention, was measured for its luminescent quantum yield and maximum emission wavelength by the following methods. The results are shown in Table 3.

### <Evaluation of luminescent quantum yield>

Compound 3 was dissolved in 2-methyltetrahydrofuran (manufactured by Aldrich, dehydrated, no stabilizer added) at room temperature to prepare a solution with a concentration of 1 × 10⁻⁵ mol/l. The solution was placed in a quartz cell equipped with a Teflon (registered trademark) cock, and nitrogen bubbling was performed for 20 minutes or more. The absolute quantum yield was measured at room temperature, and its relative value was calculated, with the value in Comparative Example 5 described below being 1.00.

For the measurement of the luminescent quantum yield, the following instruments were used.

Apparatus: C9920-02 organic EL quantum yield spectrometer manufactured by Hamamatsu Photonics K.K.

Light source: L9799-01 monochromatic light source
Detector: PMA-11 multichannel detector
Excitation light: 380 nm

### <Measurement of maximum emission wavelength>

The phosphorescence spectrum of a solution obtained by dissolving compound 3 in 2-methyltetrahydrofuran at a concentration of 1 × 10⁻⁵ mol/L at normal temperature was measured with a spectrophotometer (C9920-02 organic EL quantum yield spectrometer manufactured by Hamamatsu Photonics K.K.). The wavelength at a maximum intensity in the measured phosphorescence spectrum was used a maximum emission wavelength.

### [Comparative Examples 5 to 7]

A solution was prepared in the same manner as in Example 5 except that compound 3 was replaced with compound D-3, compound D-4, or compound D-5 shown below, and measured for its luminescent quantum yield and maximum emission wavelength. The luminescent quantum yield was expressed as a relative value, with the value of Comparative Example 5 being 1.00. Compounds D-3 to D-5 were synthesized on the basis of the description of International Publication No. 2015/087961. The results are shown in Table 3.

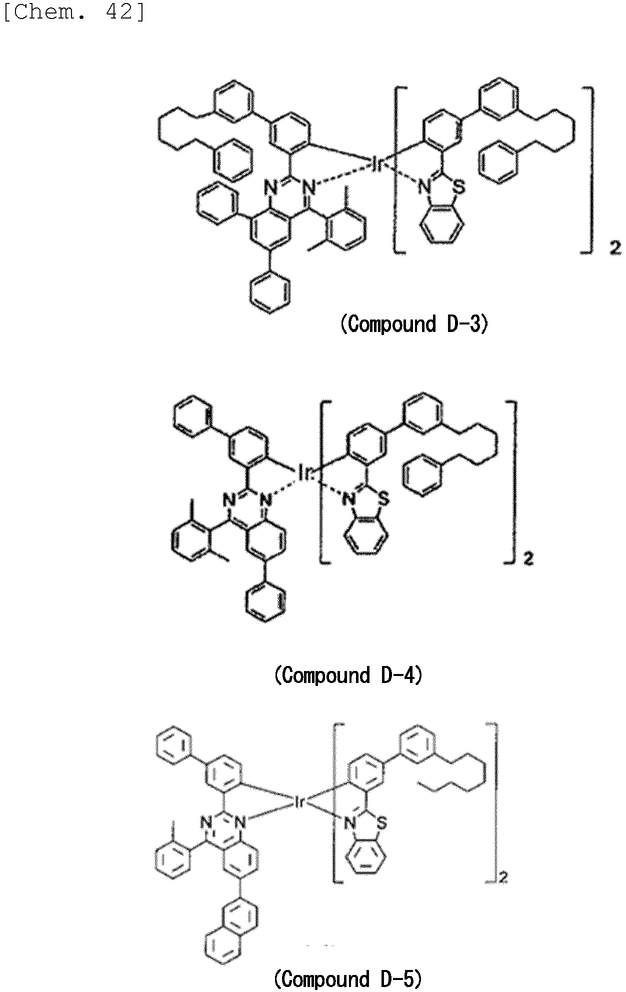

**[Table 3]**

| | Iridium complex compound | Maximum emission wavelength (nm) | Luminescent quantum yield |
|---|---|---|---|
| Example 5 | Compound 3 | 632 | 0.88 |
| Comparative Example 5 | Compound D-3 | 618 | 1 |
| Comparative Example 6 | Compound D-4 | 630 | 0.83 |
| Comparative Example 7 | Compound D-5 | 649 | 0.57 |

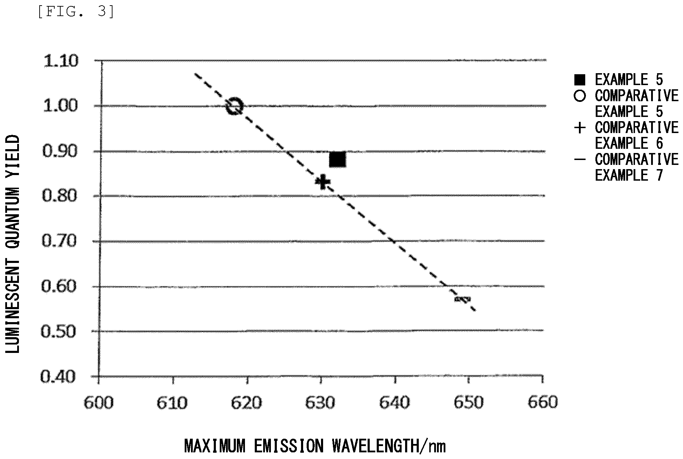

Fig. 3 shows the relationship between maximum emission wavelength and luminescent quantum yield of Example 5 and Comparative Examples 5 to 7.

It is known that iridium complex compounds having chemically similar structures often show a linear relationship between emission wavelength and quantum yield particularly in the red-light-emitting region (e.g., S. Okada, et al, Dalton Trans., 2005, 1583-1590). Comparative Examples 5 to 7 are iridium complex compounds that are combinations of a phenyl-quinazoline ligand and a phenyl-benzothiazole ligand, and the same relationship probably exists among these compounds.

The iridium complex compound of the present invention of Example 5 had a quantum yield higher than a luminescent quantum efficiency at a maximum emission wavelength of Example 5 (compound 3) represented by a line passing through data of Comparative Examples 5 to 7.

While the present invention has been described in detail using a specific embodiment, it should be apparent to those skilled in the art that various modifications can be made without departing from the spirit and scope of the present invention.

The present application is based on Japanese Patent Application No. 2017-214771 filed on November 7, 2017 and Japanese Patent Application No. 2017-214772 filed on November 7, 2017, which are incorporated herein by reference in their entirety.

### Reference Signs List

- 1: substrate
- 2: anode
- 3: hole injection layer
- 4: hole transport layer
- 5: light-emitting layer
- 6: hole blocking layer
- 7: electron transport layer
- 8: electron injection layer
- 9: cathode
- 10: organic electroluminescent element

## Claims

1. An iridium complex compound represented by formula (1) below: 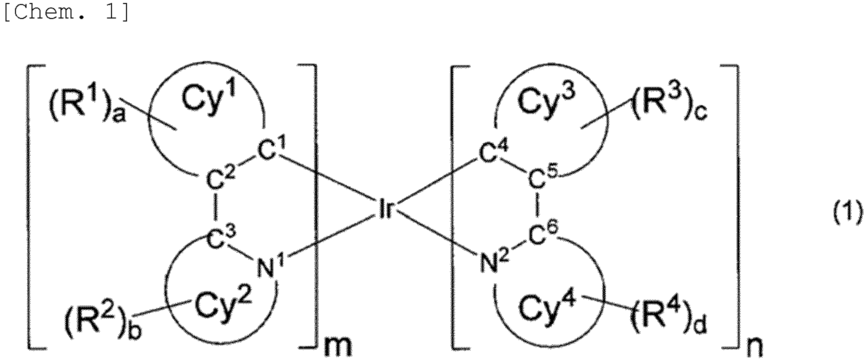 [in formula (1), Ir represents an iridium atom,
C¹ to C⁶ represent carbon atoms, N¹ and N² represent nitrogen atoms,
R¹ to R⁴ each independently represent a hydrogen atom or a substituent,
a, b, c, and d represent maximum integer numbers of possible substituents on rings Cy¹, Cy², Cy³, and Cy⁴, respectively,
m and n each represent 1 or 2, m + n is 3,
the ring Cy¹ is a fluorene structure represented by formula (2) or (2') below, 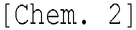 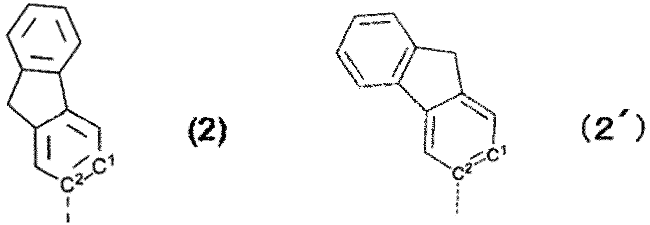
when the ring Cy¹ is represented by formula (2), the ring Cy² is a quinoline or naphthyridine structure represented by any one of formula (3) to formula (5) below,
when the ring Cy¹ is represented by formula (2'), the ring Cy² is a naphthyridine structure represented by any one of formula (3) to formula (5) below, 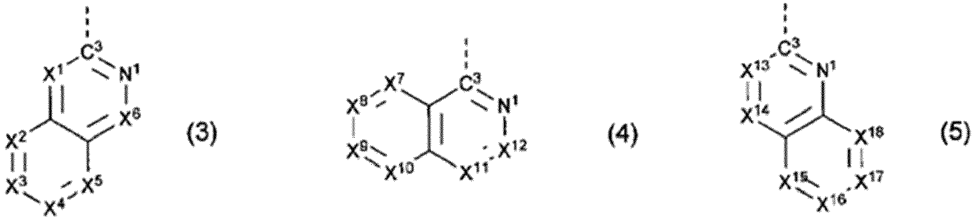 X¹ to X¹⁸ in formulae (3) to (5) each independently represent a carbon atom or a nitrogen atom,
the ring Cy³ represents an aromatic or heteroaromatic ring including the carbon atoms C⁴ and C⁵, and
the ring Cy⁴ represents a heteroaromatic ring including the carbon atom C⁶ and the nitrogen atom N²].

2. The iridium complex compound according to Claim 1, wherein the ring Cy⁴ is a structure represented by formula (6) below: 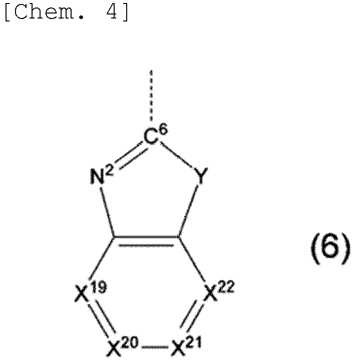 [in formula (6),
X¹⁹ to X²² each independently represent a carbon atom or a nitrogen atom,
Y represents N(-R⁵), an oxygen atom, or a sulfur atom, and R⁵ represents a hydrogen atom or a substituent].

3. The iridium complex compound according to Claim 1 or 2, wherein the ring Cy¹ is a fluorene structure represented by formula (2), and the ring Cy³ is represented by formula (8) below:

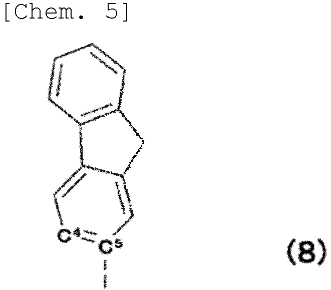

4. The iridium complex compound according to any one of Claims 1 to 3, wherein Y in formula (6) is a sulfur atom.

5. The iridium complex compound according to any one of Claims 1 to 4, wherein the ring Cy² includes two nitrogen atoms.

6. A composition comprising the iridium complex compound according to any one of Claims 1 to 5 and a solvent.

7. An organic electroluminescent element comprising the iridium complex compound according to any one of Claims 1 to 5.

8. A display device comprising the organic electroluminescent element according to Claim 7.

9. An illumination device comprising the organic electroluminescent element according to Claim 7.

10. An iridium complex compound represented by formula (7) below: 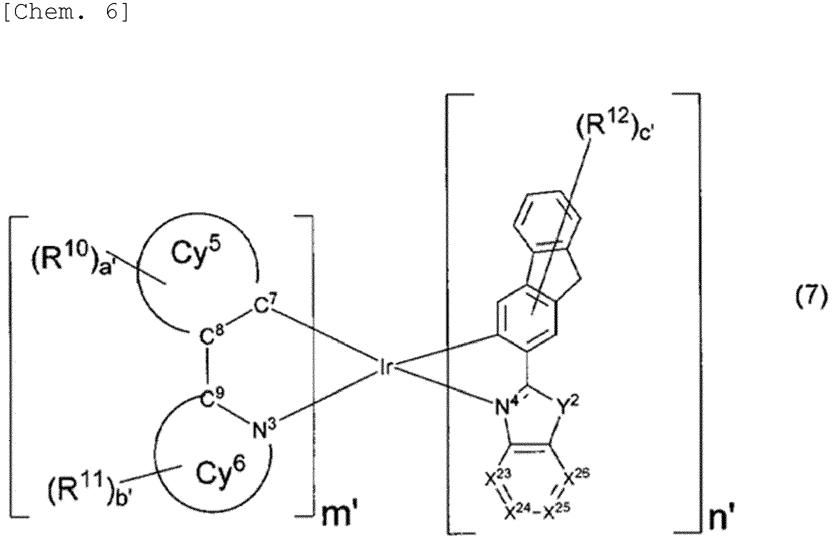 [in formula (7), Ir represents an iridium atom,
C⁷ to C⁹ represent carbon atoms, N³ and N⁴ represent nitrogen atoms,
a ring Cy⁵ represents an aromatic or heteroaromatic ring including the carbon atoms C⁷ and C⁸,
a ring Cy⁶ represents a heteroaromatic ring including the carbon atom C⁹ and the nitrogen atom N³,
X²³ to X²⁶ each independently represent an optionally substituted carbon atom or a nitrogen atom,
Y² represents an oxygen atom, a sulfur atom, or a selenium atom,
R¹⁰ to R¹² each independently represent a hydrogen atom or a substituent,
a' and b' represent maximum integer numbers of possible substituents on the rings Cy⁵ and Cy⁶, respectively, c' is 8, and
m' and n' each represent 1 or 2, m' + n' is 3].
